# EUROPÄISCHE PATENTANMELDUNG

(11) **EP 4 290 887 A1**
(43) Veröffentlichungstag der Anmeldung: **13.12.2023**
(21) Anmeldenummer: 22178294.9
(22) Anmeldetag: 10.06.2022
(51) Int. Cl.: H04R 31/00, H04R 19/00, H04R 17/00, B81C 1/00, H04R 7/14

(54) **VERFAHREN ZUR HERSTELLUNG EINER MEHRZAHL VON MEMS-WANDLERN MIT ERHÖHTER LEISTUNGSFÄHIGKEIT**

(71) Anmelder: Hahn-Schickard-Gesellschaft für angewandte Forschung e.V., 78052 Villingen-Schwenningen (DE)
(72) Erfinder: Dehé, Alfons, 72770 Reutlingen (DE); Becker, Dennis, 78166 Donaueschingen (DE)
(74) Vertreter: Hertin und Partner Rechts- und Patentanwälte PartG mbB

(57) **Zusammenfassung**

Die Erfindung betrifft bevorzugt ein Verfahren zur Herstellung eines MEMS-Wandlers umfassend eine Membran und einen Träger, wobei die Membran eine Mäanderstruktur umfassend vertikale und horizontale Abschnitten aufweist. Hierbei wird zunächst eine Formgebungskomponente bereitgestellt, die mit einem Membranschichtsystem beschichtet wird. Das Membranschichtsystem umfasst mindestens eine Aktuatorlage umfassend ein Aktuatormaterial.

Durch eine Strukturierung des Membranschichtsystems werden Membranen bereitgestellt, welche an einen Träger angebracht werden können. Die Formgebungskomponente kann vollständig entfernt werden.

Weiterhin betrifft die Erfindung bevorzugt einen MEMS-Wandler, der mittels des Verfahrens herstellbar ist.

## Beschreibung

Die Erfindung betrifft bevorzugt ein Verfahren zur Herstellung eines MEMS-Wandlers umfassend eine Membran und einen Träger, wobei die Membran eine Mäanderstruktur umfassend vertikale und horizontale Abschnitten aufweist. Hierbei wird zunächst eine Formgebungskomponente bereitgestellt, die mit einem Membranschichtsystem beschichtet wird. Das Membranschichtsystem umfasst mindestens eine Aktuatorlage umfassend ein Aktuatormaterial. Durch eine Strukturierung des Membranschichtsystems werden Membranen bereitgestellt, welche an einen Träger angebracht werden können. Die Formgebungskomponente kann vollständig entfernt werden.

Weiterhin betrifft die Erfindung bevorzugt einen MEMS-Wandler, der mittels des Verfahrens herstellbar ist.

### Hintergrund und Stand der Technik

Für die Herstellung kompakter, mechanisch-elektronischer Vorrichtungen wird heute auf vielen Anwendungsgebieten auf die Mikrosystemtechnik zurückgegriffen. Die so herstellbaren Mikrosysteme (engl. microelectromechanical system, kurz MEMS) sind äußert kompakt (Mikrometerbereich) bei gleichzeitig hervorragender Funktionalität. Aus dem Stand der Technik sind auch MEMS-Wandler, wie beispielsweise MEMS-Lautsprecher oder MEMS-Mikrofone, bekannt. Derzeitige MEMS-Lautsprecher werden zumeist als planare Membransysteme ausgeführt mit einer vertikalen Aktuierung einer schwingfähigen Membran in Emissionsrichtung. Die Anregung erfolgt beispielsweise mittels piezoelektrischer, elektromagnetischer oder elektrostatischer Aktuatoren.

Ein elektromagnetischer MEMS-Lautsprecher für Mobilgeräte wird in Shahosseini et al. 2015 beschrieben. Der MEMS-Lautsprecher weist eine versteifende Silizium-Mikrostruktur als Schallstrahler auf, wobei der bewegliche Teil an einem Träger über Silizium-Triebfedern aufgehangen wird, um große Verschiebungen mittels eines elektromagnetischen Motors aus der Ebene zu ermöglichen.

Stoppel et al. 2017 offenbart einen Zwei-Wege Lautsprecher, dessen Konzept auf konzentrischen piezoelektrischen Aktuatoren basiert. Als eine Besonderheit ist die Schwingungsmembran nicht geschlossen ausgeführt, sondern umfasst acht piezoelektrische unimorphe Aktoren, die jeweils aus einer piezoelektrischen und einer passiven Schicht bestehen. Die äußeren Tieftöner bestehen aus vier einseitig eingespannten Aktuatoren mit Trapezform, während die inneren Hochtöner durch vier dreieckige Aktuatoren gebildet werden, welche mittels einer oder mehrerer Feder mit einem starren Rahmen verbunden sind. Die Trennung der Membran soll ein verbessertes Klangbild bei höherer Leistung erlauben.

Nachteilig an derartigen planaren MEMS-Lautsprechern ist deren Limitierung in Bezug auf die Schallleistung, insbesondere bei tiefen Frequenzen. Ein Grund hierfür liegt darin, dass der erzeugbare Schalldruckpegel proportional zum Quadrat der Frequenz für eine vorgegebene Auslenkung ist. Für hinreichende Schallleistungen sind daher entweder Auslenkungen für die Schwingungsmembranen von mindestens 100 µm oder großflächige Membranen im Quadratzentimeterbereich notwendig. Beide Bedingungen sind mittels einer MEMS-Technologie nur schwer zu realisieren. Insbesondere zeigen sich die Schwierigkeiten im Rahmen möglicher Herstellungsschritte, die keine effiziente Durchführbarkeit ermöglichen.

Im Stand der Technik wurde daher vorgeschlagen, MEMS-Lautsprecher zu konzipieren, welche nicht eine geschlossene Membran zu Schwingungen in vertikaler Emissionsrichtung aufweisen, sondern eine Vielzahl von beweglichen Elementen, die zu lateralen bzw. horizontalen Schwingungen angeregt werden können. Vorteilhaft hieran ist, dass auf kleiner Fläche ein vergrößerter Volumenstrom bewegbar und somit einer erhöhte Schallleistung bereitgestellt werden kann.

Ein auf diesem Prinzip basierender MEMS-Lautsprecherwird beispielsweise in der US 2018/0179048 A1 bzw. Kaiser et al. (2019) offenbart. Der MEMS-Lautsprecher umfasst eine Mehrzahl elektrostatischer Biegeaktuatoren, welche zwischen einem Deckel- und Boden-Wafer als vertikale Lamellen angeordnet vorliegen und durch entsprechende Steuerung zu lateralen Schwingungen angeregt werden können. Hierbei bildet eine innere Lamelle eine Aktuatorelektrode gegenüber zwei äußeren Lamellen. Bis auf einen Verbindungsknoten von weiterhin galvanisch getrennten Elektroden besteht ein Luftspalt zwischen den gebogenen drei Lamellen. Liegt ein Potential innen gegen außen an, führt dies zu einer beidseitigen Anziehung aufgrund der Wölbung des Designs in Richtung einer Vorzugsrichtung, welche durch einen Anker vorgegeben ist. Die Ausbuchtungen der äußeren Lamellen dienen der Beweglichkeit. Die Rückstellkraft ist durch eine mechanische Federkraft gegeben. Ein pull-push Betrieb ist somit nicht möglich.

Nachteilig ist zudem, dass Spalten zwischen den Biegeaktuatoren und den Deckel/Boden-Wafern, welche für deren Beweglichkeit notwendig sind, zu einer Ventilation zwischen beiden Kammern führen. Hierdurch erfährt die untere Grenzfrequenz eine Begrenzung. Weiterhin ist die laterale Bewegung der Biegeaktuatoren und mithin die Schallleistung eingeschränkt, um einen pull-in Effekt und akustischen Durchschlag zu vermeiden.

In der WO 2021/144400 A1 wird ein MEMS-Wandler offenbart, der sowohl als MEMS-Lautsprecher als auch als MEMS-Mikrofon eingesetzt werden kann. Der darin beschriebene MEMS-Wandler weist eine schwingfähige Membran auf, die derart aufgebaut ist, dass sie zwei oder mehr vertikale Abschnitte umfasst, welche im Wesentlichen parallel zur vertikalen Richtung ausgebildet sind. Weiterhin umfasst die schwingfähige Membran mindestens eine Lage aus einem Aktuatormaterial und ist zumindest mit einer Elektrode endseitig kontaktiert. Hierdurch können die vertikalen Abschnitte über eine Ansteuerung der Elektrode zu horizontalen Schwingungen angeregt werden. Umgekehrt kann auch bei einer Anregung der vertikalen Abschnitte zu horizontalen Schwingungen an der Elektrode ein elektrisches Signal erzeugt werden.

Der in der WO 2021/144400 A1 offenbarte MEMS-Wandler weist deutliche Verbesserungen gegenüber dem Stand der Technik auf. Die Gestaltung der schwingfähigen Membran umfassend die vertikalen Abschnitte führt im Falle eines MEMS-Lautsprechers vorteilhaft zu einer höheren Schallleistung. Auch im Falle eines MEMS-Mikrofons wird vorteilhaft eine höhere Leistungsfähigkeit sowie Audioqualität mit einem geeigneten Klangbild erlangt. Zudem kann für die Herstellung des MEMS-Wandlers auf bewährte Prozesse der Halbleiterprozessierung zurückgegriffen werden, sodass eine kosteneffiziente Produktion ermöglicht wird.

Der in der WO 2021/144400 A1 offenbarte MEMS-Wandlerwird bevorzugt derart hergestellt, dass ein Substrat geätzt wird, vorzugsweise von einer Vorderseite, um eine Mäanderstruktur zu bilden. Daraufhin werden mindestens zwei Lagen aufgebracht, wobei mindestens eine erste Lage ein Aktuatormaterial und eine zweite Lage ein mechanisches Stützmaterial umfasst oder mindestens zwei Lagen umfassend ein Aktuatormaterial beschichtet werden. Anschließend werden die erste und/oder die zweite Lage mit einer Elektrode kontaktiert.

Hinsichtlich des Herstellungsverfahrens des in der WO 2021/144400 A1 offenbarten MEMS-Wandlers liegt ein Bedarf an Optimierung vor. So ist insbesondere das Ätzen des Substrats, wodurch ein Träger für die schwingfähige Membran bereitgestellt wird, aufwendig. Das Ätzen des Substrats erfolgt vorzugsweise durch ein DRIE-Ätzen, was jedoch kostenintensiv ist. Des Weiteren weist das DRIE-Ätzen Einschränkungen bzgl. der Opferschichtenauswahl (Stoppoxide) sowie der Möglichkeit, unterschiedliche Tiefen beim Ätzen zu erreichen, auf. Ein alternatives Verfahren zur Bereitstellung eines Trägers durch nasschemisches KOH-Ätzen (Kaliumhydroxid) benötigt einen vergrößerten räumlichen Bereich, was zu einem größeren Bauraum führt und mit Verlusten hinsichtlich der Kompaktheit des MEMS-Wandlers einhergeht. Insbesondere bei der Herstellung einer Vielzahl von MEMS-Wandlern führt der größere Platzbedarf für den Trägerrahmen zwischen den einzelnen MEMS-Wandlern zu einer weniger effizienten Nutzung des Wafers und höheren Kosten.

Im Lichte des Standes der Technik liegt mithin ein Bedarf vor, verbesserte oder alternative Verfahren zur Herstellung eines MEMS-Wandlers zu bieten.

### Aufgabe der Erfindung

Aufgabe der Erfindung war es, die Nachteile des Standes der Technik zu beseitigen. Insbesondere war es eine Aufgabe der Erfindung, ein Verfahren zur Herstellung von MEMS-Wandlern bereitzustellen, welches sich durch eine hohe Prozesseffizienz und Wirtschaftlichkeit auszeichnet, eine geringe Anfälligkeit für Fehler aufweist, leicht skalierbar ist und eine Herstellung von MEMS-Wandlern gewährleistet, welche durch ausgezeichnete akustische Eigenschaften und kompakte Ausmaße gekennzeichnet sind.

### Zusammenfassung der Erfindung

Die Aufgabe der Erfindung wird gelöst durch die unabhängigen Ansprüche. Vorteilhafte Ausgestaltungen der Erfindung sind in den abhängigen Ansprüchen offenbart.

In einem ersten Aspekt betrifft die Erfindung ein Verfahren zur Herstellung mindestens eines MEMS-Wandlers zur Interaktion mit einem Volumenstrom eines Fluids umfassend
- einen Träger und
- eine Membran zur Erzeugung oder Aufnahme von Druckwellen des Fluids in einer vertikalen Richtung, welche von dem Träger gehalten wird,
wobei die Membran eine Mäanderstruktur mit vertikalen Abschnitten und horizontalen Abschnitten aufweist, wobei die vertikalen Abschnitte im Wesentlichen parallel zur vertikalen Richtung ausgebildet sind und die horizontalen Abschnitte die vertikalen Abschnitte miteinander verbinden, wobei die Membran mindestens eine Aktuatorlage aus einem Aktuatormaterial umfasst und mit mindestens einer Elektrode kontaktiert vorliegt, sodass durch Ansteuerung der mindestens einen Elektrode die vertikalen Abschnitte zu horizontalen Schwingungen anregbar sind oder sodass bei Anregung der vertikalen Abschnitte zu horizontalen Schwingungen an der mindestens einen Elektrode ein elektrisches Signal erzeugbar ist, dadurch gekennzeichnet, dass das Verfahren folgende Schritte umfasst:
a) Bereitstellung einer Formgebungskomponente,
b) Beschichtung der Formgebungskomponente mit einem Membranschichtsystem umfassend mindestens die Aktuatorlage, wobei das Membranschichtsystem nach der Beschichtung auf der Formgebungskomponente eine Mäanderstruktur umfassend vertikale Abschnitte und horizontale Abschnitte aufweist,
c) Bereitstellung der Membran durch eine Strukturierung des Membranschichtsystems,
d) vollständige Entfernung der Formgebungskomponente,
e) Anbringung der Membran an einem Träger, sodass die Membran von dem Träger gehalten wird.

Die Erfinder haben erkannt, dass das bevorzugte Verfahren zur Herstellung eines MEMS-Wandlers erhebliche Verbesserungen in vielen Aspekten erzielt. Insbesondere die vollständige Entfernung der Formgebungskomponente wirkt sich sowohl auf die Effizienz des Herstellungsverfahrens als auch auf den herstellbaren MEMS-Wandler überaus vorteilhaft aus.

Zum einen wird auf die Notwendigkeit verzichtet, mehrere Ätzverfahren anwenden zu müssen, um einen Träger bereitstellen zu können, an dem die Membran zur Erzeugung oder Aufnahme von Druckwellen angebracht wird.

Stattdessen wird eine (vorrübergehende) Formgebungskomponente bereitgestellt, welche nach einer Beschichtung zur Ausbildung eines Membranschichtsystems wieder vollständig entfernt werden kann. Dies stellt einen wesentlichen Unterschied gegenüber beispielsweise dem in der WO 2021/144400 A1 offenbarten Verfahren zur Herstellung eines MEMS-Wandlers dar. Hierbei wird vorgeschlagen, ein Substrat vor der Beschichtung mit einem Membranschichtsystem zu strukturieren, wobei Rahmenbereiche des Substrates einen Träger für die Membran bilden. Zu diesem Zweck wird ausgehend von einer Vorderseite ein Ausgangssubstrat geätzt, z. B. durch ein DRIE-Ätzen, um eine für die Mäanderstruktur der Membran kongruente Struktur auf dem Substrat bereitzustellen. Anschließend werden Beschichtungsprozesse zum Auftragen der Membranschichten ausgeführt und daraufhin wieder abschnittsweise durch ein weiteres DRIE-Ätzen die Membran rückseitig freigelegt, wobei ein Rahmen des Substrates bestehen bleibt und den Träger bildet. Ein vollständiges, rückseitiges Entfernen des Substrates ist mittels eines einfachen Ätzprozesses in dem Prozessdesign nicht möglich, da andernfalls kein Träger bereitgestellt werden kann.

Erfindungsgemäß wurde erkannt, dass durch eine Anbringung der Membran an einen separaten Träger auf die Formgebungskomponente verzichtet werden kann und eine vollständige (rückseitige) Entfernung möglich ist. Der vermeintliche Nachteil einer Bereitstellung eines separaten Trägers wird durch eine Reihe von Vorteilen aufgehoben, welche insbesondere mit der möglichen vollständigen Entfernung der Formgebungskomponente einhergehen.

So kann auf ein aufwendiges DRIE-Ätzen zur rückseitigen Freilegung der Membran verzichtet werden. Stattdessen kann beispielsweise ein (kostengünstiges) und hoch selektives nasschemisches Ätzen eingesetzt werden. In dieser Hinsicht sind vorteilhaft auch keine separaten Grinding-Verfahrensschritte bzw. Schleifschritte vordem DRIE-Ätzen notwendig.

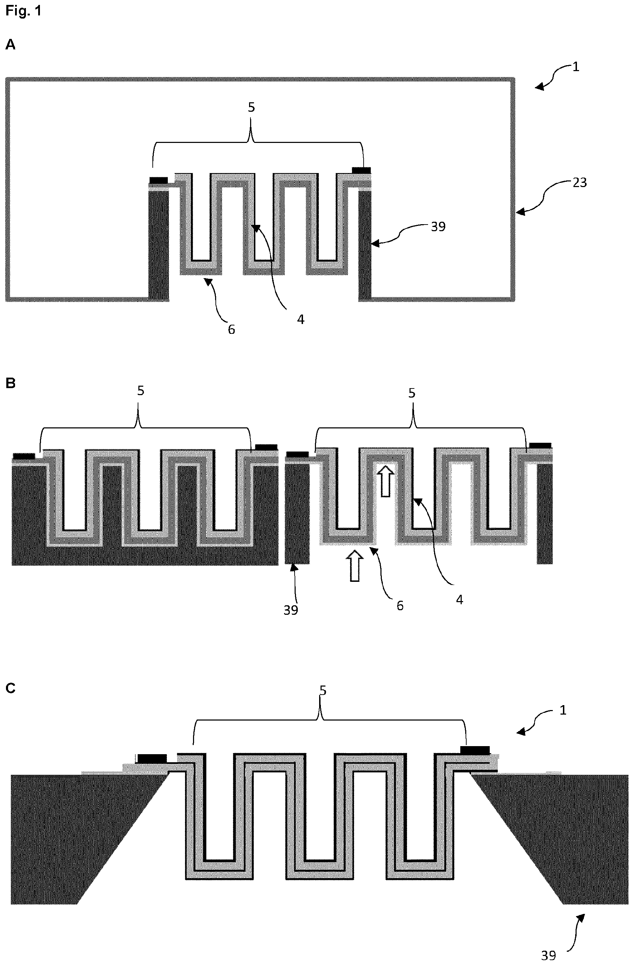

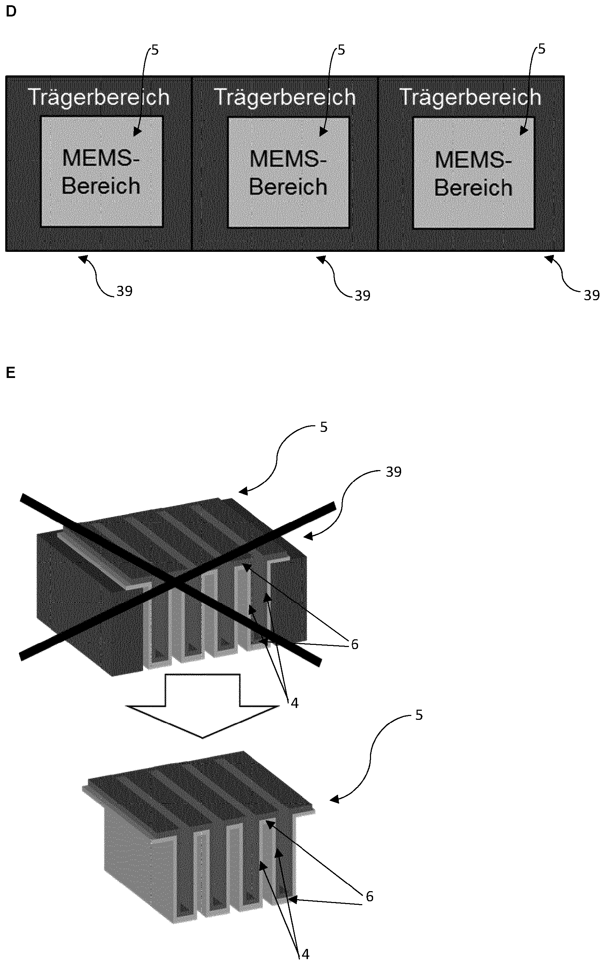

Dadurch, dass die Formgebungskomponente vollständig entfernt wird und keine äußerer Träger verbleiben muss, können bei der Herstellung einer Vielzahl von MEMS-Wandlern diese auf dem Wafer zudem äußerst kompakt positioniert werden. Ein erhöhtes Spacing der einzelne Chips, um einem erhöhten Platzbedarf Rechnung zu tragen, sofern bei einem KOH-Ätzen ein Träger als Rahmen verbleiben soll (vgl. Fig. 1C, D), ist nicht notwendig. Ebenso kann bei der Herstellung einer Vielzahl von MEMS-Wandern auf einem Wafer auf ein Dicing verzichtet werden.

Vorteilhaft werden mit der erfindungsgemäßen Lösung mithin Zeit sowie Kosten gespart, sodass mit geringerem Materialaufwand innerhalb verkürzter Zeit eine höhere Stückzahl an MEMS-Wandlern hergestellt werden kann.

Die bevorzugten Verfahrensschritte a) - e) sind zum Erreichen der Vorteile nicht auf obige Reihenfolge eingeschränkt. Vorzugsweise können die Schritte a) - e), je nach Ausführungsform, der erfindungsgemäßen Aspekte beispielsweise zeitlich überlappend, simultan oder in einer anderen Reihenfolge ausgeführt werden.

So kann es beispielsweise bevorzugt sein, nach einer Beschichtung des Membranschichtsystems auf die Formgebungskomponente dieses zu strukturieren und mit einer Stützstruktur zu verbinden, wodurch eine Stabilisierung ermöglicht wird, um zuverlässig die Formgebungskomponente vollständig zu entfernen. Vorteilhaft wird mithin durch einen Verfahrensschritt, nämlich der vollständige Entfernung der Formgebungskomponente, eine Vielzahl von Membranen bereitgestellt, welche zunächst stabilisiert an einer Stützstruktur vorliegen, aber von dieser zu einem Träger transportiert und angebracht werden können. Somit kann es bevorzugt sein, dass Schritt d), die vollständige Entfernung der Formgebungskomponente sowie Schritt e), die Anbringung der (einzelnen) Membranen an jeweils einen Träger, nach dem Schritt c), einer Strukturierung des Membranschichtsystems zur Bereitstellung einzelner Membranen, ausgeführt wird.

Ebenso kann es bevorzugt sein, dass eine Strukturierung des Membranschichtsystems zur Bereitstellung einer oder mehrerer Membranen (Schritt c) erfolgt, nachdem das Membranschichtsystem mit einer Trägerstruktur verbunden wurde (Schritt e). In diesem Fall erfolgt die Anbringung des Membranschichtsystems mit einer Trägerstruktur auch bevorzugt vor der vollständigen Entfernung der Formgebungskomponenten (Schritt d), durch welche die einzelnen Membranen bereitgestellt werden. Durch Anbringung des Membranschichtsystems an einer Trägerstruktur vor der vollständigen Entfernung der Formgebungskomponente kann auf eine separate Stützstruktur verzichtet werden. Nach der Entfernung der Formgebungskomponente wird durch eine bereichsweise Trennung der Trägerstruktur entsprechend einzelne Membrane auf einzelnen Träger bereitgestellt.

Die im Folgenden ausgeführten Erläuterungen zu den einzelnen Verfahrensschritten gelten somit für unterschiedliche Kombinationen der Reihenfolge der Verfahrensschritte und sind nicht auf die zu Illustrationszwecken gewählte Reihenfolge beschränkt.

In einem ersten Schritt kann es bevorzugt sein, die Formgebungskomponente bereitzustellen. Vorzugsweise wird die Formgebungskomponente derart (strukturiert) bereitgestellt, dass auf einer zugänglichen Seite, vorzugsweise einer Vorderseite, eine zu der gewünschten Mäanderstruktur der Membran kongruente Mäanderstruktur vorliegt. Die Struktur der Formgebungskomponente legt mithin vorzugsweise die Mäanderstruktur der Membran fest. Mit anderen Worten beschrieben, kann die Formgebungskomponente auch als Schablone bzw. Matrize für die Formgebung des Membranschichtsystems aufgefasst werden.

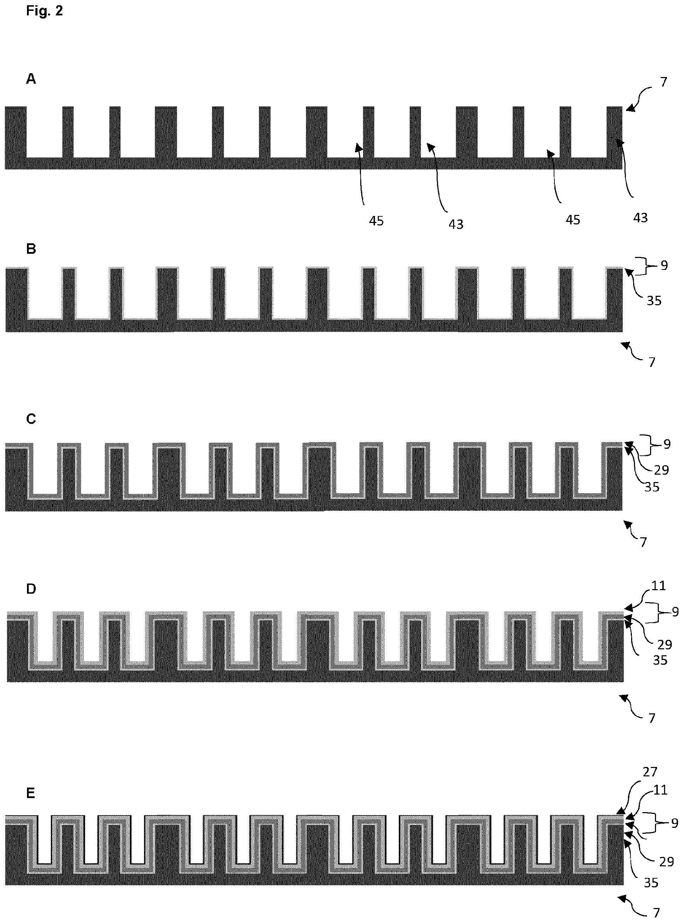

Bevorzugt weist die Formgebungsstruktur eine derartige Struktur auf, dass nach der Beschichtung des Membranschichtsystems eine Mäanderstruktur umfassend vertikale Abschnitte und horizontale Abschnitte vorliegt. Vorzugsweise kann hierfür die Formgebungskomponente als Kammstruktursubstrat umfassend Kammfinger und Leerbereiche vorliegen, sodass bei der Beschichtung des Membranschichtsystems eine zur Kammstruktur deckungsgleich gefaltete Membran bereitgestellt werden kann (siehe Fig. 2A).

Die Formgebungsstruktur kann durch eine Strukturierung eines (Halbleiter-)Substrats bereitgestellt werden, beispielsweise durch ein DRIE-Ätzen eines Substrats, um die Kammfinger und Leerbereiche für das Kammstruktursubstrat als Formgebungsstruktur zu erzeugen. Nach der Bereitstellung der Formgebungskomponente erfolgt vorzugsweise die Beschichtung des Membranschichtsystems. Das Kammstruktursubstrat umfasst bevorzugt einen Hauptstrang, Kammfinger und Leerbereiche. Die Kammfinger bezeichnen Abschnitte, die im Wesentlichen orthogonal auf den Hauptstrang vorliegen und durch die Leerbereiche voneinander getrennt sind. Der Hauptstrang kann somit als Stütze für die Kammfinger angesehen werden. Die Leerbereiche bezeichnen bevorzugt Abschnitte, in denen kein Substratmaterial mehr vorliegt. Das Kammstruktursubstrat wird bevorzugt durch ein Ätzverfahren bereitgestellt. Dabei wird bevorzugt ein (Halbleiter-)Substrat ausgehend von einer Vorderseite geätzt, sodass Kavitäten am Substrat hinterlassen werden, wobei die Kavitäten wiederrum die Leerbereiche bilden, während die nichtgeätzten Abschnitte als Kammfinger fungieren.

Die Mäanderstruktur der Membran kann insbesondere durch die Maße der Formgebungskomponente, z. B. als Kammstruktursubstrat, eingestellt werden. So korrespondiert die Länge der Kammfinger eines Kammstruktursubstrats vorzugsweise mit der Länge der vertikalen Abschnitte der Membran. Die Breite der Kammfinger gibt die Breite horizontaler Abschnitte vor, welche die vertikalen Abschnitte an ihrem (vorderseitigen) oberen Bereich miteinander verbinden. Die Breite der Leerbereiche korrespondiert mit der Breite der horizontalen Abschnitte, welche die vertikalen Abschnitte an ihrem unteren Bereich miteinander verbinden.

Durch die Bereitstellung eines Kammstruktursubstrats, bei welchem die Breite der Kammfinger gleich der Breite der Leerbereiche oder Zwischenbereiche ist, können vorzugsweise für die Membran gleichlange horizontale Abschnitte gewährleistet werden.

Mit dem Membranschichtsystem sind im Sinne der Erfindung vorzugsweise eine oder mehrere Schichten gemeint, welche der Bereitstellung der Membran des MEMS-Wandlers dienen. Das Membranschichtsystem umfasst insbesondere eine Schicht bzw. Lage umfassend ein Aktuatormaterial, die als Aktuatorlage bezeichnet wird, die im Folgenden noch ausführlicher erläutert und insbesondere für die Erzeugung oder Detektion von Schwingungen der Membran genutzt wird. Die Begriffe "Schicht" und "Lage" können im erfindungsgemäßen Kontext synonym verwandt werden. Bevorzugt umfasst das Membranschichtsystem neben der Aktuatorlage weitere Schichten, insbesondere eine Top-Elektrode, eine Bottom-Elektrode und/oder eine mechanische Stützlage. Weiterhin kann das Membranschichtsystem vorzugsweise eine Opferschicht umfassen, die bevorzugt vor der Beschichtung weiterer Schichten des Membranschichtsystem zunächst auf die Formgebungskomponente beschichtet wird.

Durch einfache Strukturierung des Membranschichtsystems können vorzugweise Unterbrechungen bereitgestellt werden, welche Endbereiche für die am Träger anbringbare Membranen definieren. Durch die Beschichtung der Formgebungskomponente kann vorteilhafterweise mithin simultan ein Membranschichtsystem für eine Vielzahl an Membranen bereitgestellt werden, deren Ausmaße durch die Formgebungskomponente einerseits und der später vorgenommenen Strukturierung andererseits bestimmt werden kann.

Bevorzugt erfolgt die Beschichtung des Membranschichtsystems ausgehend von einer Vorderseite. Mit der Vorderseite der Formgebungskomponente ist bevorzugt jene Seite gemeint, bei welcher die Formgebungskomponente eine Struktur (beispielsweise Kammstruktur) aufweist, auf welche das Membranschichtsystem durch Beschichtung gebildet werden soll. Bevorzugt wird die Formgebungskomponente derart bereitgestellt, dass diese von einer Vorderseite entsprechend strukturiert vorliegt, während die Formgebungskomponente rückseitig nicht strukturiert ist.

Die vollständige Entfernung der Formgebungskomponente erfolgt bevorzugt ausgehend von einer Rückseite der Formgebungskomponente. Mit der Rückseite der Formgebungskomponente ist bevorzugt mithin die von dem Membranschichtsystem abgewandte Seite gemeint.

Eine Anbringung der Membran an einem Träger erfolgt vorzugsweise ebenfalls von der Vorderseite, sodass die Vorderseite der Membran wiederum einer Schallöffnung im Träger zugewandt ist und mithin vorzugweise eine Richtung der Schallemission bzw. Schalldetektion des fertigen MEMS-Wandlers kennzeichnet.

Bevorzugt erfolgt die vollständige Entfernung der Formgebungskomponente durch ein nasschemisches Ätzverfahren. Vorteilhafterweise führt dies dazu, dass dünnere Opferschichten eingesetzt werden können, als dies beispielsweise mit einem DRIE-Ätzprozess notwendig wäre, sodass es zu einer vorteilhaften Materialeinsparung kommt. Durch den Einsatz nasschemischer Ätzverfahren liegt zudem eine höhere Materialauswahl für die Opferschicht vor, was sich zusätzlich positiv auf die Wirtschaftlichkeit auswirkt.

Zudem besteht eine erhöhte Designflexibilität hinsichtlich der Ausgestaltung der vertikalen und/oder horizontalen Abschnitte des bevorzugten MEMS-Wandlers. Insbesondere entfallen etwaige Einschränkungen im Zusammenhang mit einer rückseitigen Freistellung der Membran, da nasschemische Ätzverfahren zur vollständigen Entfernung der Formgebungskomponente für beliebige Längen und/oder Breiten der vertikalen und/oder horizontalen Abschnitte effizient ausgeführt werden können.

Die vollständige Entfernung der Formgebungskomponente meint im erfindungsgemäßen Kontext bevorzugt eine Entfernung, bei der keine funktionellen Komponenten der Formgebungskomponente (beispielsweise als Träger) bestehen bleiben. Der durchschnittliche Fachmann weiß, dass nach einer vollständigen Entfernung der Formgebungskomponente nicht ausgeschlossen werden kann, dass geringfügige Bestandteile noch bestehen bleiben. Allerdings ist es bevorzugt, dass die bei der vollständigen Entfernung der Formgebungskomponente die Formgebungskomponente im Wesentlichen vollständig entfernt wird.

Begriffe wie Begriffe wie im Wesentlichen, ca. etc. beschreiben bevorzugt einen Toleranzbereich von weniger als ± 40 %, bevorzugt weniger als ± 20 %, besonders bevorzugt weniger als ± 10 %, noch stärker bevorzugt weniger als ± 5 % und insbesondere weniger als ± 1 % und umfassen insbesondere den exakten Wert. Ähnlich beschreibt bevorzugt Größen, die ungefähr gleich sind. Teilweise beschreibt bevorzugt zu mindestens 5 %, besonders bevorzugt zu mindestens 10 %, und insbesondere zu mindestens 20 %, in einigen Fällen zu mindestens 40 %.

Die Anbringung der Membran an den Träger kann vorzugsweise durch eine Überführung der Membran von einer Stützstruktur an einen Träger erfolgen. Wie weiter unten erläutert, kann hierzu beispielsweise eine Bestückungskomponente verwandt werden, welche geeignet ist, (einzelne) Membranen von der Stützstruktur zu entfernen und auf einen Träger aufzubringen, auf dem beispielsweise ein leitfähiger Klebstoff zur Kontaktierung vorliegt.

Ebenso kann es bevorzugt sein, dass vor der Entfernung der Formgebungskomponente eine Trägerstruktur an den Membranen und an dem Membranschichtsystem angebracht wird. Nach der Entfernung der Formgebungskomponente dient die Trägerstruktur der Stabilisierung der Membran(en) bzw. des Membranschichtsystems. Eine zusätzliche Stützstruktur ist nicht notwendig. Durch entsprechende Trennung der Trägerstruktur (mit aufgebrachten Membranen bzw. dem Membranschichtsystem) können mithin mehrere MEMS-Wandler erhalten werden, wobei jeweils von einem Träger eine Membran gehalten wird. Im fertigen MEMS-Wandler dient der Träger vorzugsweise sowohl einer Aufhängung der Membran als auch für deren elektrische Kontaktierung. Zu dem Zweck kann der Träger bevorzugt auch Durchkontaktierungen aufweisen, die als solche und/oder als Umkontaktierungen eingesetzt werden können, um elektrische Signale aufzubringen oder zu erfassen.

Durch die prozesstechnische Trennung der Bereitstellung einer Formgebungskomponente zur Formung des Membranschichtsystems bzw. der Membran von einem separaten Träger, auf den die Membran später angebracht wird, besteht eine erhöhte Freiheit in Bezug auf die Auswahl bzw. Gestaltung des Trägers.

Auch auf den herstellbaren MEMS-Wandler als solchen wirkt sich das bevorzugte Verfahren mithin vorteilhaft aus. So können herstellbare Membranen ausgehend von dem Membranschichtsystem auf einen freiwählbaren Träger angebracht werden, beispielsweise nach einer Entfernung von einer Stützstruktur oder durch Austrennen aus einer Trägerstruktur. Durch die erhöhte Flexibilität im Hinblick auf die Aufhängung oder Kontaktierung der endseitigen Bereiche der Membran am Träger können besonders kompakte MEMS-Wandler bereitgestellt werden, deren akustische Anbindung zudem optimiert werden kann.

So kann es beispielsweise bevorzugt sein, die Membran auf einen Träger über einen leitfähigen Prozesswerkstoff anzubringen, der sowohl eine elektrische Kontaktierung erlaubt als auch einen akustischen Abschluss bildet. Darüber hinaus kann das Rückvolumen, je nach Ausmaße einer bevorzugten Abdeckung, variabel gestaltet werden in Abhängigkeit von dem gewünschten Einsatzzweck. Vorteilhafterweise kann durch das bevorzugte Verfahren mithin ein hinsichtlich der akustischen Anforderungen besonders geeigneter MEMS-Wandler bereitgestellt werden.

Die Konstruktionsweise des mittels des Verfahrens herstellbaren MEMS-Wandlers verbindet hierbei vorteilhaft die Möglichkeit hoher Schalleistung mit einer vereinfachten Ansteuerung.

Im Gegensatz zu bekannten planaren MEMS-Lautsprechern muss beispielsweise die schwingfähige Membran selbst nicht über eine große Fläche von mehreren Quadratzentimeter oder mit Auslenkungen von mehr als 100 µm betrieben werden, um einen ausreichenden Schalldruck zu erzeugen. Stattdessen kann die Mehrzahl der vertikalen Abschnitte der schwingfähigen Membran mit kleinen horizontalen bzw. lateralen Bewegungen von wenigen Mikrometern ein vergrößertes Gesamtvolumen in vertikaler Emissionsrichtung bewegen.

Gleichzeitig kann eine vereinfachte Ansteuerung erreicht werden. Während im Stand der Technik eine Vielzahl von piezoelektrischen Aktuatoren an den horizontalen Abschnitten kontaktiert werden müssen, kann der hier beschriebene MEMS-Wandler mittels mindestens einer vorzugsweise endseitigen Elektrode betrieben werden. Dies reduziert den Herstellungsaufwand, minimiert Fehlerquellen und führt zudem inhärent zu einer synchronen Steuerung der vertikalen Abschnitte zu horizontalen Schwingungen.

Auf diese Weise können die Luftvolumina, welche zwischen den vertikalen Abschnitten vorliegen, überaus präzise durch die horizontalen Schwingungen entlang der vertikalen Emissionsrichtung bewegt werden.

Ebenso wird auf diese Weise die Bereitstellung eines besonders leistungsstarken MEMS-Mikrofones mit hoher Audioqualität ermöglicht. Der Aufbau des MEMS-Mikrofons ähnelt strukturell dem des MEMS-Lautsprechers, insbesondere im Hinblick auf die Ausgestaltung der schwingfähigen Membran. Anstelle einer Ansteuerung der Elektroden zur Erzeugung von horizontalen Schwingungen und mithin von Schalldruckwellen, ist das MEMS-Mikrofon jedoch dafür ausgelegt, Schalldruckwellen in selbiger vertikaler Richtung aufzunehmen. Bevorzugt liegen zwischen den vertikalen Abschnitten mithin Luftvolumina vor, welche bei Aufnahme von Schallwellen entlang einer vertikalen Detektionsrichtung bewegt werden. Durch die Schalldruckwellen werden die vertikalen Abschnitte zu horizontalen Schwingungen angeregt, sodass das Aktuatormaterial ein entsprechendes periodisches elektrisches Signal erzeugt, welches durch eine elektronische Schaltung ausgelesen werden kann.

Unter dem Begriff MEMS-Wandler ist somit sowohl ein MEMS-Mikrofon als auch ein MEMS-Lautsprecher zu verstehen. Allgemein bezeichnet der MEMS-Wandler einen Wandler zur Interaktion mit einem Volumenstrom eines Fluids, der auf MEMS-Technologie basiert und dessen Strukturen zur Interaktion mit dem Volumenstrom bzw. zur Aufnahme oder Erzeugung von Druckwellen des Fluids eine Dimensionierung im Mikrometerbereich (1 µm bis 1 000 µm) aufweisen. Bei dem Fluid kann es sich sowohl um ein gasförmiges als auch flüssiges Fluid handeln. Die Strukturen des MEMS-Wandlers, insbesondere der schwingfähigen Membran, sind zur Erzeugung oder Aufnahme von Druckwellen des Fluids ausgelegt.

Beispielsweise kann es sich, wie im Falle eines MEMS-Lautsprechers oder MEMS-Mikrofons, um Schalldruckwellen handeln. Der MEMS-Wandler kann sich aber ebenso als Aktuator oder Sensor für andere Druckwellen eignen. Der MEMS-Wandler ist somit bevorzugt eine Vorrichtung oder ein Gerät, welches Druckwellen (z. B. akustische Signale als Schallwechseldrücke) in elektrische Signale umwandelt oder umgekehrt (Umwandlung elektrischer Signale in Druckwellen, beispielsweise akustische Signale).

Auch Anwendungen des MEMS-Wandlers als ein Energy-Harvester sind möglich, wobei pneumatische oder hydraulische Wechseldrücke genutzt werden. Das elektrische Signal kann in diesen Fällen als gewonnene elektrische Energie abgeführt, gespeichert oder anderen (Verbraucher-)geräten zugeführt werden.

Ein MEMS-Lautsprecher bezeichnet bevorzugt einen Lautsprecher, welcher auf MEMS-Technologie basiert und dessen klangerzeugende Strukturen mindestens teilweise eine Dimensionierung im Mikrometerbereich (1 µm bis 1000 µm) aufweisen. Bevorzugt können beispielsweise die vertikalen Abschnitte der schwingfähigen Membran in Breite, Höhe und/oder Dicke eine Dimension im Bereich von weniger als 1000 µm aufweisen. Hierbei kann es auch bevorzugt sein, dass beispielsweise lediglich die Höhe der vertikalen Abschnitte im Mikrometerbereich dimensioniert sind, während beispielsweise die Länge eine größere Dimension und/oder die Dicke eine kleinere Größe aufweisen kann.

Ein MEMS-Mikrofon bezeichnet bevorzugt ein Mikrofon, welches auf einer MEMS-Technologie basiert und dessen klangaufnehmende Strukturen mindestens teilweise eine Dimensionierung im Mikrometerbereich (1 µm bis 1000 µm) aufweisen. Bevorzugt können beispielsweise die vertikalen Abschnitte der schwingfähigen Membran in Breite, Höhe und/oder Dicke eine Dimension im Bereich von weniger als 1000 µm aufweisen. Hierbei kann es auch bevorzugt sein, dass beispielsweise lediglich die Höhe der vertikalen Abschnitte im Mikrometerbereich dimensioniert sind, während beispielsweise die Länge eine größere Dimension und/oder die Dicke eine kleinere Größe aufweisen kann.

Bevorzugt umfasst der MEMS-Wandler die schwingfähige Membran zur Erzeugung oder Aufnahme von Druckwellen des Fluids in einer vertikalen Richtung. Damit bezeichnet die schwingfähige Membran diejenige Struktur, die es ermöglicht, ein elektrisches Signal nach einer Aufnahme von Druckwellen zu generieren oder durch die Aufbringung eines elektrischen Signals Druckwellen zu erzeugen. Dazu ist es bevorzugt, dass die schwingfähige Membran mindestens eine Aktuatorlage aus einem Aktuatormaterial aufweist. Vorzugsweise ist die schwingfähige Membran derart strukturiert, dass sie eine Mäanderstruktur umfassend vertikale und horizontale Abschnitte aufweist.

Eine Mäanderstruktur bezeichnet bevorzugt eine aus einer Abfolge zueinander im Wesentlichen orthogonaler Abschnitte im Querschnitt gebildete Struktur. Bei den zueinander orthogonalen Abschnitten handelt es sich bevorzugt um vertikale und horizontale Abschnitte der schwingfähigen Membran. Besonders bevorzugt ist die Mäanderstruktur im Querschnitt rechteckig. Es kann aber auch bevorzugt sein, dass die Mäanderstruktur im Querschnitt eine Sägezahnform (Zick-Zack-Form) aufweist oder kurvenförmig bzw. wellenförmig ausgestaltet ist. Dies ist insbesondere der Fall, sofern die vertikalen Abschnitte nicht exakt parallel mit der vertikalen Emissions- oder Detektionsrichtung ausgerichtet vorliegen, sondern einen Winkel beispielsweise von ± 30°, bevorzugt ± 20°, besonders bevorzugt ± 10° mit der vertikalen Richtung einschließen.

Die horizontalen Abschnitte können in bevorzugten Ausführungsformen ebenfalls nicht exakt unter einem orthogonalen Winkel von 90° zur vertikalen Emissions- oder Detektionsrichtung stehen, sondern beispielsweise einen Winkel zwischen 60° und 120°, bevorzugt zwischen 70° und 110°, besonders bevorzugt zwischen 80° und 100° mit der vertikalen Richtung einschließen.

Vorzugsweise sind die vertikalen und/oder horizontalen Abschnitte mindestens abschnittsweise oder über deren gesamte Länge geradlinig, die vertikalen und/oder horizontalen Abschnitte können jedoch auch mindestens abschnittsweise oder über deren gesamte Länge kurvig ausgestaltet sein. Im Falle einer kurvenförmigen bzw. welligen Form der vertikalen und/oder horizontalen Abschnitte der schwingfähigen Membran im Querschnitt bezieht sich die Ausrichtung bevorzugt auf eine Tangente an die vertikalen und/oder horizontalen Abschnitte an deren jeweiligen Mittelpunkten.

Die entsprechende Form der Membran(en) kann durch eine Ausgestaltung der Formgebungskomponente, wie obig beschrieben, gewährleistet werden.

Während die schwingfähige Membran bevorzugt horizontal zur Schallemissionsrichtung oder Schalldetektionsrichtung ausgerichtet vorliegt, werden die Schallwellen durch eine Aktuierung der vertikalen Abschnitte erzeugt oder umgekehrt detektiert.

Bevorzugt dient die Lage aus einem Aktuatormaterial in den vertikalen Abschnitten als Bestandteil eines mechanischen Bimorphs, wobei durch Ansteuerung der Aktuatorlage über die Elektrode eine laterale Wölbung der vertikalen Abschnitte bewirkt wird oder wobei durch eine induzierte laterale Wölbung ein entsprechendes elektrisches Signal erzeugt wird. Ein Bimorph bezeichnet bevorzugt eine Struktur, die zwei Schichten umfasst, wobei durch eine Zusammenwirkung der beiden Schichten eine Verschiebung und/oder Wölbung ermöglicht wird.

Die Mäanderstruktur entspricht bevorzugt einer entlang der Breite gefalteten Membran. Im Sinne der Erfindung kann eine schwingfähige Membran daher bevorzugt auch als Faltenbalg bezeichnet werden. Die parallelen Falten des Faltenbalges bilden bevorzugt die vertikalen Abschnitte. Die Verbindungsabschnitte zwischen den Falten bilden bevorzugt die horizontalen Abschnitte. Bevorzugt sind die vertikalen Abschnitte länger als die horizontalen Abschnitte, beispielsweise um einen Faktor 1,5, 2, 3, 4 oder mehr. Die horizontalen Abschnitte bezeichnen bevorzugt diejenigen Strukturen, die eine Verbindung zwischen zwei oder mehr vertikalen Abschnitten ermöglichen.

Die Performance des MEMS-Wandlers, insbesondere eines MEMS-Lautsprechers oder MEMS-Mikrofons, kann wesentlich von der Anzahl und/oder Dimensionierung der vertikalen Abschnitte bestimmt werden.

In bevorzugten Ausführungsformen umfasst die schwingfähige Membran mehr als 3, 4, 5, 10, 15, 20, 30, 40, 50, 100 oder mehr vertikale Abschnitte.

In weiteren bevorzugten Ausführungsformen umfasst die schwingfähige Membran weniger als 10000, 5000, 2000 oder 1000 oder weniger vertikale Abschnitte.

Die bevorzugte Anzahl von vertikalen Abschnitten führt zu hohen Schallleistungen auf kleinsten Chip-Oberflächen, ohne dass das Klangbild oder die Audioqualität leidet.

Bevorzugt sind die vertikalen Abschnitte flächig, das bedeutet insbesondere, dass ihre Ausdehnung in jede der zwei Dimensionen (Höhe, Breite) ihrer Fläche größer ist als in einer hierzu senkrechten Dimension (der Dicke). Beispielsweise können Größenverhältnisse von mindestens 2:1, bevorzugt mindestens 5: 1, 10: 1 oder mehr bevorzugt sein.

Im Sinne der Erfindung entspricht die Höhe der vertikalen Abschnitte bevorzugt der Dimension entlang der Richtung der Schallemission oder Schalldetektion, während die Dicke der vertikalen Abschnitte bevorzugt die Summe der Schichtdicke der einen oder mehreren Lagen entspricht, welche die vertikalen Abschnitte bilden. Die Länge der vertikalen Abschnitte entspricht bevorzugt einer zur Höhe bzw. Dicke orthogonalen Dimension. In den Querschnittsansichten der unten aufgeführten Abbildungen sind Höhe und Dicke schematisch (nicht zwangsläufig skalengetreu) dargestellt, während die Dimension der Länge einer (nicht sichtbaren) Zeichnungstiefe der Abbildungen entspricht.

In einer bevorzugten Ausführungsform beträgt die Höhe der vertikalen Abschnitte zwischen 1 µm und 1000 µm, bevorzugt zwischen 10 µm und 500 µm. Auch Zwischenbereiche aus den vorgenannten Bereichen können bevorzugt sein, wie beispielsweise 1 µm bis 10 µm, 10 µm bis 50 µm, 50 µm bis 100 µm, 100 µm bis 200 µm, 200 µm bis 300 µm, 300 µm bis 400 µm, 400 µm bis 500 µm, 600 µm bis 700 µm, 700 µm bis 800 µm, 800 µm bis 900 µm oder auch 900 µm bis 1000 µm. Ein Fachmann erkennt, dass die vorgenannten Bereichsgrenzen auch kombiniert werden können, um weitere bevorzugte Bereich zu erhalten, wie beispielsweise 10 µm bis 200 µm, 50 µm bis 300 µm oder auch 100 µm bis 600 µm.

In einer bevorzugten Ausführungsform beträgt die Dicke der vertikalen Abschnitte zwischen 100 nm und 10 µm, bevorzugt zwischen 500 nm und 5 µm. Auch Zwischenbereiche aus den vorgenannten Bereichen können bevorzugt seien wie beispielsweise 100 nm bis 500 nm, 500 nm bis 1 µm, 1 µm bis 1,5 µm, 1,5 µm bis 2 µm, 2 µm bis 3 µm, 3 µm bis 4 µm, 4 µm bis 5 µm, 5 µm bis 6 µm, 6 µm bis 7 µm, 7 µm bis 8 µm, 8 µm bis 9 µm oder auch 9 µm bis 10 µm. Ein Fachmann erkennt, dass die vorgenannten Bereichsgrenzen auch kombiniert werden können, um weitere bevorzugte Bereich zu erhalten, wie beispielsweise 500 nm bis 3 µm, 1 µm bis 5 µm oder auch 1500 nm bis 6 µm.

In einer bevorzugten Ausführungsform beträgt die Länge der vertikalen Abschnitte zwischen 10 µm und 10 mm, bevorzugt zwischen 100 µm und 1 mm. Auch Zwischenbereiche aus den vorgenannten Bereichen können bevorzugt seien wie beispielsweise 10 µm bis 100 µm, 100 µm bis 200 µm, 200 µm bis 300 µm, 300 µm bis 400 µm, 400 µm bis 500 µm, 500 µm bis 1000 µm, 1 mm bis 2 mm, 3 mm bis 4 mm, 4 mm bis 5 mm, 5 mm bis 8 mm oder auch 8 mm bis 10 mm. Ein Fachmann erkennt, dass die vorgenannten Bereichsgrenzen auch kombiniert werden können, um weitere bevorzugte Bereich zu erhalten, wie beispielsweise 10 µm bis 500 µm, 500 µm bis 5 µm oder auch 1 mm bis 5 mm.

Mit den vorgenannten bevorzugten Dimensionierungen der schwingfähigen Membran bzw. der vertikalen Abschnitte kann ein besonders kompakter MEMS-Wandler, insbesondere MEMS-Lautsprecher oder MEMS-Mikrofon, bereitgestellt werden, welcher gleichzeitig eine hohe Leistungsfähigkeit mit ausgezeichnetem Klangbild oder Audioqualität verbindet. Vorteilhaft können die genannten Maße besonders einfach durch eine entsprechende Ausgestaltung der Formgebungskomponente erlangt werden. Vorzugsweise bestimmt die Struktur der Formgebungskomponente die Struktur der schwingfähigen Membran umfassend vertikale und horizontale Abschnitte.

Die Richtungsangaben vertikal und horizontal (bzw. lateral) beziehen sich bevorzugt auf eine Vorzugsrichtung, in welcher die schwingfähige Membran zur Erzeugung oder Aufnahme von Druckwellen des Fluids ausgerichtet ist. Bevorzugt ist die schwingfähige Membran horizontal zwischen mindestens zwei Bereichen eines Trägers aufgehangen, während die vertikale Richtung (Interaktionsrichtung mit dem Fluid) zur Erzeugung oder Aufnahme von Druckwellen orthogonal dazu vorliegt. Im Falle eines MEMS-Lautsprechers entspricht die vertikale (Interaktions-)Richtung der vertikalen Schallemissionsrichtung des MEMS-Lautsprechers. Vertikal meint in dem Fall bevorzugt die Richtung der Schallemission, während horizontal eine dazu orthogonale Richtung meint. Im Falle eines MEMS-Mikrofons entspricht die vertikale (Interaktions-)Richtung der vertikalen Schalldetektionsrichtung des MEMS-Mikrofons. Vertikal meint in dem Fall bevorzugt die Richtung der Schalldetektion bzw. Aufnahme, während horizontal eine dazu orthogonale Richtung meint.

In einer weiteren bevorzugten Ausführungsform ist das Verfahren dadurch gekennzeichnet, dass eine Mehrzahl von MEMS-Wandlern hergestellt wird, wobei für eine Herstellung der Mehrzahl von MEMS-Wandlern das Membranschichtsystem auf der Formgebungskomponente zur Bildung von einzelnen Membranen strukturiert wird, wobei besonders bevorzugt die einzelnen Membranen durch Unterbrechungen getrennt vorliegen, welche vorzugsweise gesamtheitlich nach der Beschichtung des Membranschichtsystems oder Schicht für Schicht gebildet werden.

Die erhöhte Prozesseffizienz des Verfahrens zeigt sich insbesondere in der Möglichkeit der effizienten Herstellung einer großen Anzahl von MEMS-Wandlern, vorzugsweise ausgehend von einer Formgebungskomponente bzw. eines Substrates als Formgebungskomponente. Eine Mehrzahl von MEMS-Wandlern meint bevorzugt 2, 3, 4, 5, 10, 20, 50, 100, 500, 1000 oder mehr MEMS-Wandler.

Die Mehrzahl von MEMS-Wandlern kann bevorzugt mittels einer Formgebungskomponente bereitgestellt werden, wobei vorzugsweise zunächst die Aufbringung eines Membranschichtsystems auf der strukturierten Vorderseite der Formgebungskomponente erfolgt. Anschließend kann zur Definition der einzelnen Membran, eine (laterale) Strukturierung des Membranschichtsystems durch die Bildung von Unterbrechungen erfolgen. Eine Unterbrechung meint bevorzugt einen Bereich, in dem eine Entfernung einer oder mehrerer (vorzugsweise sämtlicher) Schichten des Membranschichtsystem vorgenommen wird. Besonders bevorzugt handelt es um linienförmige Unterbrechungen, welche im Falle der Ausbildung der Formgebungskomponente als Kammstruktur auf den Kammfingern vorgenommen wurden. Die Unterbrechungen liegen somit im Bereich horizontaler Abschnitte der Membran vor, welche die vertikalen Abschnitte am vorderseitigen Ende miteinander verbinden. Die Unterbrechungen sind bevorzugt im Wesentlichen linienförming ausgestaltet und zeichnen sich durch eine geringe Linienbreite aus. Vorzugsweise weisen die Unterbrechungen Linienbreiten von weniger als 50 µm auf, bevorzugt weniger als 30 µm, 20 µm, 10 µm, 5 µm, 2 µm oder auch weniger als 1 µm.

Mittels der Unterbrechungen kann die Dimensionierung und/oder Anzahl der einzelnen Membranen festgelegt werden, welche aus dem Membranschichtsystem gebildet werden sollen.

Besonders bevorzugt kann durch entsprechende Bildung von Unterbrechungen ein Array von Membranen definiert werden, wobei die Ausdehnung des Arrays durch die Abmaße der Formgebungskomponente bestimmt ist. Beispielsweise kann es bevorzugt sein, auf einer strukturierten Formgebungskomponente mit quadratischen Abmaßen in einem Bereich von 10 mm bis 500 mm einen entsprechend dimensionierten Array von Membranen zu bilden. Für eine Breite und Länge einer Membran von jeweils 1 mm kann beispielsweise, je nach Größe der Formgebungskomponente, ein Array von 10x10 bis zu 500x500 Membranen gebildet werden.

Das Bilden der Unterbrechungen kann mit bekannten Mitteln des Standes der Technik erfolgen, beispielsweise durch Ätzverfahren. Hierbei können die Unterbrechungen gesamtheitlich nach der Beschichtung des Membranschichtsystems vorgenommen werden, wobei mithin mehrere (vorzugsweise sämtliche) Schichten des Membranschichtsystems durch einen einzelnen Schritt strukturiert werden. Ebenso kann es bevorzugt sein, dass die Unterbrechungen Schicht für Schicht zu bilden. D. h., dass nach der Beschichtung jeweils einer Schicht des Membranschichtsystems sogleich eine laterale Strukturierung durch eine selektive Entfernung der Schicht an den zu formenden Unterbrechungen vorgenommen wird.

Vorteilhaft können die Membranen lediglich durch dünne linienförmige Unterbrechungen äußerst platzeffizient auf der Formgebungskomponente gebildet werden, sodass eine Bereitstellung der Mehrzahl von Membranen und entsprechender Mehrzahl von MEMS-Wandlern mit sehr geringem Materialaufwand verbunden ist.

In einer weiteren bevorzugten Ausführungsform ist das Verfahren dadurch gekennzeichnet, dass die Formgebungskomponente durch eine Anwendung eines Trockenätzverfahrens und/oder eines nasschemischen Ätzverfahrens auf ein Substrat bereitgestellt wird, wobei bevorzugt das Trockenätzverfahren ein physikalisches, ein chemisches und/oder ein physikalisch-chemisches Trockenätzverfahren ist, wobei besonders bevorzugt das Trockenätzverfahren ausgewählt ist aus einer Gruppe umfassend reaktives lonenätzen (RIE) und/oder reaktives lonentiefenätzen (DRIE), wobei bevorzugt als nasschemisches Ätzverfahren ein KOH-Ätzen eingesetzt wird.

Unter Trockenätzen fasst man in der Halbleitertechnologie und in der Mikrosystemtechnik eine Gruppe von abtragenden Mikrostrukturverfahren zusammen, die nicht auf nasschemischen Reaktionen (wie nasschemisches Ätzen) basieren. Der Materialabtrag erfolgt dabei entweder durch beschleunigte Teilchen oder mithilfe plasmaaktivierter Gase. Es werden also je nach Verfahren chemische, physikalische oder physikalisch-chemische Effekte ausgenutzt.

Das reaktive lonenätzen (englisch: reactive ion etching, RIE) ist ein ionenunterstützter Reaktivitätsprozess. RIE ist wegen der guten Kontrollierbarkeit des Ätzverhaltens ein Verfahren zur Herstellung von topografischen Strukturen für die Mikro-, Halbleiter- und Nanosystemtechnologie. Das Verfahren lässt durch physikalisch-chemischen Abtrag sowohl eine isotrope (richtungsunabhängig) als auch eine anisotrope Ätzung zu. Das Ätzen erfolgt durch aufgeladene Teilchen (Ionen), die in einem Gasplasma erzeugt wurden. Eine entsprechende Maskierung (z. B. durch Fotolithografie erzeugt) der Oberfläche gibt die Formgebung der Strukturen. Beispielsweise können durch die Maskierung Kavitäten und damit Leerbereiche an einem Substrat ausgebildet werden, wobei die nichtgeätzten Abschnitte Kammfinger eines Kammstruktursubstrats als Formgebungskomponente darstellen können.

Reaktives lonentiefenätzen (englisch. deep reactive ion etching, DRIE) ist eine Weiterentwicklung des reaktiven lonenätzens (RIE) und ein hoch anisotroper Trockenätzprozess für die Herstellung von Mikrostrukturen in Substraten mit einem Aspektverhältnis von bis zu 50:1, wobei Strukturtiefen von einigen 100 Mikrometern erreicht werden können. Der DRIE-Prozess ist ein zweistufiger, alternierender Trockenätzprozess, bei dem sich Ätz- und Passivierungsschritte abwechseln. Ziel ist es, möglichst anisotrop zu ätzen, das heißt richtungsabhängig, senkrecht zur Substrat-Oberfläche. Auf diese Weise können beispielsweise sehr schmale Kavitäten bzw. Vertiefungen geätzt werden. Vorteilhaft liegen somit beispielsweise besonders schmale Kammfinger und/oder Leerbereiche des Kammstruktursubstrates als Formgebungskomponente vor, welche in schmale vertikale und/oder horizontale Abschnitte der Membran(en) übersetzt werden können.

Bevorzugt erfolgt das nasschemische Ätzen mithilfe eines flüssigen Reaktanten. Dabei kann es sich um eine Chemikalie handeln, die die zu ätzende Formgebungskomponente auflöst oder um ein chemisches Gemisch, das zuerst die Formgebungskomponente oxidiert und dann das Oxid auflöst. Vorzugsweise kann der Reaktant eine stärkere Säure sein, z. B. Flusssäure für ein Siliziumsubstrat, oder eine schwächere Säure sein, z. B. Zitronensäure für ein Galliumarsenidsubstrat. Im erfindungsgemäßen Kontext hat sich das KOH-Ätzen zur Bereitstellung der Formgebungskomponente als besonders vorteilhaft erwiesen. Vorteilhaft sind nasschemische Ätzverfahren schnell ausführbar, sodass hohe Ätzraten erreicht werden können und die Prozesszeit des bevorzugten Verfahrens verringert wird. Vorteilhaft kann auch eine hohe Selektivität mit einfachen Mitteln zur Ausführung des nasschemischen Ätzverfahrens erreicht werden, z. B. mit Bädern und/oder nasschemischen Sprays.

Die vorgenannten Ätzverfahren sind dem Fachmann bekannt und können vorteilhaft in bevorzugten Ausführungsformen des Verfahrens Anwendung finden. Insbesondere eignen sich die genannten Ätzverfahren, um zur Bildung der Formgebungskomponente auf einem Substrat eine Struktur bereitzustellen, die kongruent zu der Mäanderstruktur der Membran ist, wobei sich bevorzugt die Mäanderstruktur nach der Beschichtung der Formgebungskomponente mit dem Membranschichtsystem ergibt.

In Abhängigkeit der gewünschten Struktur der Formgebungskomponente kann in einem bereitgestellten Substrat Vertiefungen eingebracht werden, um eine anzustrebende Mäanderstruktur der Membran zu erhalten. Dabei können vorteilhafterweise Ätzverfahren gewählt werden, welche eine effiziente Durchführung sowie eine optimale Formgebung des Membranschichtsystems gewährleisten. Beispielsweise weist Kaliumhydroxid (KOH-Ätzen) eine deutliche Vorzugsrichtung für das Ätzen entlang einer <110> Orientierung (Schreibweise für Miller-Indizes) eines Siliziumkristalls versus einer <111 > Orientierung auf. So können Ätzraten gewählt werden, um eine besonders schnelle Bereitstellung der Formgebungskomponente zu ermöglichen.

In einer weiteren bevorzugten Ausführungsform ist das Verfahren dadurch gekennzeichnet, dass Formgebungskomponente ein Material umfasst, ausgewählt aus einer Gruppe bestehend aus Monosilizium, Polysilizium, Siliziumdioxid, Siliziumcarbid, Siliziumgermanium, Siliziumnitrid, Nitrid, Germanium, Kohlenstoff, Galliumarsenid, Galliumnitrid, Indiumphosphid und Glas. Bevorzugt wird die Formgebungskomponente durch eine Strukturierung eines Substrats gebildet. Die Strukturierung kann beispielsweise zu einem Kammstruktursubstrat als Formgebungskomponente führen, wobei die Strukturierung bevorzugt unter Anwendung von Ätzverfahren erfolgt. Bevorzugt ist das Material der Formgebungskomponente ein Halbleitermaterial, sodass ein Halbleitersubstrat (Wafer) genutzt werden kann, um dieses zu strukturieren und damit die Formgebungskomponente bereitzustellen. Der durchschnittliche Fachmann weiß, dass die Begriffe "Wafer" und "(Halbleiter-)Substrat" synonym verwandt werden können.

Obig genannte Materialien sind in der Halbleiter- und/oder Mikrosystemtechnik besonders einfach und kostengünstig zu bearbeiten und eignen sich ebenfalls gut für eine Massenherstellung. Ebenso sind diese Materialien für ein Dotieren und/oder ein Beschichten besonders gut geeignet, um eine gewünschte zwischenzeitliche stabile Verbindung mit dem Membranschichtsystem zu erhalten und/oder eine optimale im Wesentlichen vollständige Entfernung zu ermöglichen. Die bevorzugten vorgenannten Materialien der Formgebungskomponente bieten vielfältige Vorteile aufgrund der Verwendbarkeit standardisierter Verfahrenstechniken.

Die Strukturierung und Abmaße der Formgebungskomponente wird entsprechend der gewünschten Anzahl sowie Dimensionierung der Membranen gewählt. Die Formgebungskomponenten kann beispielsweise in der Fläche eine charakteristische Ausdehnung (z.B. Durchmesser, Länge und/oder Breite) in einem Bereich zwischen 10 mm und 500 mm aufweisen, während eine Dicke bzw. Höhe (größte Ausdehnung orthogonal zur Fläche) in einem Bereich von 100 µm bis 1000 µm. Die Einbringung einer Kammstruktur wie obig erläutert mit entsprechenden Dimensionen zur Ausbildung einer gewünschten Membran mit Mäanderstruktur erfolgen, wobei aufgrund der makroskopischen Ausdehnung in der Fläche eine Vielzahl von Membranen auf einer Formgebungskomponente bereitstellbar ist.

In einer weiteren bevorzugten Ausführungsform ist das Verfahren dadurch gekennzeichnet, dass die Formgebungskomponente durch ein nasschemisches Ätzverfahren vollständig entfernt wird, wobei bevorzugt das nasschemische Ätzverfahren ausgewählt ist aus einer Gruppe umfassend ein KOH- und/oder ein TMAH-Ätzen.

Vorteilhafterweise können durch den Einsatz eines nasschemischen Ätzverfahrens dünnere Opferschichten eingesetzt werden, sodass das Material der Opferschichten gespart und damit die Prozesseffizienz des bevorzugten Verfahrens begünstigt wird. Des Weiteren ist das nasschemische Ätzverfahren einfach und kontrolliert ausführbar, sodass eine zuverlässige vollständige Entfernung der Formgebungskomponente gewährleistet wird. Vorteilhaft ist die Selektivität des nasschemischen Ätzverfahrens hoch, sodass das Risiko unerwünschter Ätzprozesse, Schädigungen und/oder eventueller Kontaminationen auf ein Minimum reduziert wird.

Zudem kann vorteilhaft darauf verzichtet werden, mehrfache Ausführungen von Trockenätzverfahren und/oder physikalisch-chemischen Ätzverfahren, wie z. B. das DRIE-Ätzen, vorzunehmen, welche zeitintensiv und kostensensitiv sind. Durch die einmalige Ausführung eines nasschemischen Ätzverfahrens wird mithin eine erheblich gesteigerte Prozesseffizienz erreicht.

Beim nasschemischen Ätzverfahren werden bevorzugt die chemischen Bindungen der Formgebungskomponente durch Ätzmedien aufgebrochen und in lösliche Bestandteile überführt. Als besonders geeignete Ätzverfahren im erfindungsgemäßen Kontext hat sich das KOH- und/oder TMAH-Ätzen herausgestellt.

Beim KOH-Ätzen wird bevorzugt Kaliumhydroxid (KOH) in Lösung eingesetzt, um die Formgebungskomponente im Wesentlichen vollständig zu entfernen. Beim TMAH-Ätzen wird bevorzugt eine Lösung umfassend Tetramethylammoniumhydroxid (TMAH) eingesetzt. Beide nasschemische Ätzverfahren weisen vorteilhafterweise eine hervorragende Selektivität hinsichtlich der Materialauswahl für die Opferschicht und/oder Formgebungskomponente auf.

In weiteren bevorzugten Ausführungsformen erfolgt die vollständige Entfernung der Formgebungskomponente durch ein Trockenätzverfahren, wobei bevorzugt das Trockenätzverfahren ein physikalisches, ein chemisches und/oder ein physikalisch-chemisches Trockenätzverfahren ist, wobei besonders bevorzugt das Trockenätzverfahren ausgewählt ist aus einer Gruppe umfassend reaktives lonenätzen (RIE) und/oder reaktives lonentiefenätzen (DRIE).

Ebenfalls kann es bevorzugt sein, dass die Formgebungskomponente durch ein Dampfätzverfahren (Ätzen durch den Einsatz eines Ätzmittels als Dampf bzw. als Gas) vollständig entfernt wird. Beispielsweise kann als Dampfätzverfahren ein Xenondifluorid-Dampfätzen (englisch: XeF₂ vapor etching) durchgeführt werden. Vorteilhaft geht das isotrope Xenondifluorid-Dampfätzen mit einer hohen Selektivität für (Halbleiter-)Substrate einher, insbesondere für Silizium.

Die genannten Ätzverfahren zur vollständigen Entfernung der Formgebungskomponente können einzeln oder in Kombination miteinander durchgeführt werden.

In einer bevorzugten Ausführungsform ist das Verfahren dadurch gekennzeichnet, dass nach der Strukturierung des Membranschichtsystems mehrere Membranen mithilfe einer lösbaren Verbindung mit einer Stützstruktur verbunden werden.

Durch eine Verbindung mit der Stützstruktur kann vorteilhafterweise jene Stabilität für die Membran(en) erzielt werden, welche nach der vollständigen Entfernung der Formgebungskomponente benötigt wird. Insbesondere wird vorteilhaft durch die Stützstruktur eine Beibehaltung der Mäanderstruktur der Membranen gewährleistet und das Risiko eines Formverlustes reduziert. Da die Stützstruktur selbst nicht Bestandteil des MEMS-Wandlers ist, sondern lediglich der vorübergehenden Stabilisierung der Membranen dient, kann die Stützstruktur insbesondere unter kostentechnischen Gesichtspunkten ausgewählt werden. Beispielsweise kann die Stützstruktur aus einem flachen Kunststoffsubstrat oder als Folie, vorzugsweise als Klebefolie, ausgebildet sein. Im Grunde eignen sich verschiedenste Materialien und geometrische Formen der Stützstrukturen, sofern diese eine hinreichende Stabilität für die Membranen gewährleisten können und sich zudem für eine lösbare Ausbildung der Verbindung eignen.

Die lösbare Verbindung der Membranen mit der Stützstruktur dient der späteren Übergabe Membran(en) an die Träger, wobei, wie untenstehend erläutert, beispielsweise eine Bestückungskomponente zum Einsatz kommen kann.

Vorzugsweise liegt die lösbare Verbindung derart vor, dass sie entlang der Unterbrechungen des Membranschichtsystems und mithin der Endbereiche der einzelnen Membranen aufgebracht ist. Bei der lösbaren Verbindung kann es sich bevorzugt um, eine dekomposierbare Verbindung handeln, sodass ausgehend von dem Membranschichtsystem die Membranen frei von etwaigen Schädigungen entfernt werden können.

Beispielsweise kann es sich bei der lösbaren Verbindung um einen Klebstoff, bevorzugt einen UV-Klebstoff handeln. Ein UV-Klebstoff bezeichnet einen Klebstoff, der durch die Bestrahlung mittels UV-Strahlen aushärtet. Gelöst werden können UV-Klebstoffe beispielsweise durch die Zugabe von Hitze, d. h. einer thermischen Wirkung und/oder unter Einsatz von entsprechenden Lösungsmitteln. Vorzugsweise umfasst ein UV-Klebstoff Epoxidharz und/oder Acrylat. Ebenfalls kann die lösbare Verbindung ein thermisch und/oder chemisch lösbarer Klebstoff sein. Thermisch lösbare Klebstoffe können beispielsweise ausgewählt sein aus einer Gruppe umfassend Holzleime, Elastomere und/oder Silikonkleber. Chemisch lösbare Klebstoffe, d. h. Klebstoffe, deren Verbindung durch den Einsatz einer chemischen Lösung aufgelöst werden kann, können beispielsweise Polyurethan umfassen.

In einer bevorzugten Ausführungsform ist das Verfahren dadurch gekennzeichnet, dass die Membran durch eine Bestückungskomponente von einer Stützstruktur entfernt wird, wobei bevorzugt nach einer Entfernung der Membran von der Stützstruktur die Membran an dem Träger angebracht wird.

Mit der Bestückungskomponente ist bevorzugt eine Vorrichtung gemeint, mit der es ermöglicht wird, die Membran aus dem Membranschichtsystem bzw. von der Stützstruktur nach der vollständigen Entfernung der Formgebungskomponente zu entfernen. Die Bestückungskomponente kann beispielsweise dazu eingestellt sein, einen Niederdruck aufzubringen, sodass durch einen Druckunterschied die Membran von der lösbaren Verbindung bzw. der Stützstruktur gelöst wird. In weiteren Ausführungsformen kann auch eine Vakuumspannvorrichtung (englisch: *porous chucks*) und/oder eine Drucknadel (englisch: *push needle*) eingesetzt werden. Dabei wird vorzugsweise ein poröser Körper eingesetzt, beispielsweise ein poröser keramischer Werkstoff, wobei der Niederdruck durch die Poren des porösen Körpers appliziert wird. Durch eine bevorzugt im Wesentlichen gleichmäßige Verteilung der Poren und/oder der Porengröße wird eine gewünschte Saugkraft erzeugt unter gleichzeitiger Gewährleistung des Formerhalts der Mäanderstruktur der Membran. Vorteilhaft kann hierdurch eine besonders zuverlässige Entfernung der Membran von dem Membranschichtsystem erzielt. Ebenfalls kann es bevorzugt sein, für die Bestückungskomponente ein Pick-and-Place-Tool einzusetzen.

Insbesondere die vorgenannten bevorzugten Bestückungskomponenten haben sich als besonders zuverlässig erwiesen, um bei einem Transport von der Stützstruktur zum Träger die Form der filigranen Bestandteilen der Membran nicht zu beeinträchtigen. Darüber hinaus können die bevorzugten Bestückungskomponenten, wie beispielsweise ein Pick-and-Place-Tool gleichzeitig den Prozess des Lösens, beispielsweise durch ein Erhitzen im Falle eines thermisch lösbaren Klebstoffs, unterstützen. Es versteht sich zudem, dass es auch bevorzugt sein kann, gleichzeitig mit einer Mehrzahl von Bestückungskomponenten eine entsprechende Mehrzahl von Membranen von einer Stützstruktur zu den jeweiligen Trägern zu transportieren. Die Bestückungskomponenten können entsprechend dimensioniert werden, um insbesondere durch eine parallele Prozessierung die Herstellungszeit zu reduzieren.

Bevorzugt wird nach der Entfernung der Membran von der Stützstruktur die Membran an dem Träger angebracht. Bevorzugt kann dies direkt mittels der Bestückungskomponente erfolgen, sodass nach der Entfernung der Membran die Anbringung an den Träger in einem kontinuierlichen Verfahrensablauf ermöglicht wird. Vorteilhafterweise werden damit aufwendige Prozesssierungsschritte vermieden, um eine Kontaktierung der Membran mit dem Träger zu ermöglichen. Stattdessen liefert das bevorzugte Verfahren die Option, mithilfe der Bestückungskomponente eine automatisierte Abfolge der Entfernung der Membran und der präzisen Anbringung an dem Träger zu gewährleisten.

In einer bevorzugten Ausführungsform ist das Verfahren dadurch gekennzeichnet, dass die Membran an dem Träger über einen leitfähigen Prozesswerkstoff angebracht wird, wobei bevorzugt der leitfähige Prozesswerkstoff ausgewählt ist aus einer Gruppe umfassend ein leitfähiger Klebstoff oder ein leitfähiges Lotmaterial.

Bei dem Träger handelt es sich bevorzugt um eine Struktur, welche eine im Wesentlichen durchgehende Umrandung aufweist, sodass die Membran an Endbereichen stabil positioniert werden kann. Der Träger als solcher ist bevorzugt stabil und biegesteif, sodass eine ausreichende Festigkeit gegeben ist.

Bevorzugt weist der Träger eine oder mehrere Öffnungen auf, die insbesondere als Schalleintrittsöffnung oder Schallaustrittsöffnung fungieren.

Der Begriff der "Schalleintrittsöffnung" wird bevorzugt in Ausführungsformen verwandt, in denen der MEMS-Wandler als MEMS-Mikrofon eingesetzt wird. Durch die Schalleintrittsöffnung gelangt hierbei der Schall zur Membran, welche durch die Schallwellen in Schwingungen versetzt wird Ein hierdurch erzeugtes Signal, welches auf den eintreffenden Schall schließen lässt, kann vorzugsweise mittels einer elektronischen Schaltung ausgelesen werden, welche sich ebenfalls auf dem Träger befindet.

Der Begriff der "Schallaustrittsöffnung" wird hingegen bevorzugt in Ausführungsformen verwandt, in denen der MEMS-Wandler als ein MEMS-Lautsprechers verwandt wird. Durch die Schallaustrittsöffnung gelangt der Schall ausgehend von einer schwingenden Membran in die Umgebung, wobei die Schwingungen der Membran bevorzugt von einer elektronischen Schaltung erzeugt werden.

Bevorzugt wird ein leitfähiger Prozesswerkstoff eingebracht, um gleichzeitig eine mechanische und elektrische Verbindung zwischen dem Träger und der Membran zu ermöglichen. Der leitfähige Prozesswerkstoff kann bevorzugt an Endbereichen der Membran aufgebracht werden, bevor die Membran auf den Träger positioniert wird. Mit den Endbereichen der Membran sind insbesondere laterale Bereiche der Membran gemeint, sodass die Membran bevorzugt entlang ihrer Umrandung mit dem Träger verbunden wird. Der leitfähige Prozesswerkstoff kann bevorzugt ebenfalls zunächst auf den Träger angebracht werden, um anschließend die Anbringung der Membran auf den Träger auszuführen. Eine Anbringung der Membran am Träger erfolgt hierbei bevorzugt vorderseitig. D. h. der Träger kontaktiert die Membran an den lateralen Bereichen insbesondere ausgehend von einer Vorderseite der Membran, d. h. jener Seite der Membran, welche im Membranschichtsystem von der Formgebungskomponente abgewandt vorlag und welche im hergestellten MEMS-Wandler in Richtung der Schallemission bzw. Schalldetektion zeigt.

Bevorzugt liegt der leitfähige Prozesswerkstoff an dem Träger oder der Membran als geschlossener Ring vor, um eine optimale Befestigung der Membran am Träger und ein akustischen Abschluss der Membran an lateralen (bzw. horizontalen) Abschnitten zu ermöglichen.

Mit einem leitfähigen Prozesswerkstoff ist bevorzugt ein elektrisch leitfähiger Prozesswerkstoff gemeint. Mithilfe des Prozesswerkstoffes wird vorteilhaft eine zuverlässige, stabile und langanhaltende Verbindung zwischen der Membran und dem Träger gewährleistet. Insbesondere wird vorteilhaft zudem sowohl ein akustischer Abschluss als auch eine elektrische Kontaktierung der Membran (bzw. insbesondere deren Aktuatorlage) mit einer bevorzugten elektronischen Schaltung ermöglicht. So können beispielsweise elektrische Verbindungen, z. B. Drahtbonds, zwischen einer elektronischen Schaltung und dem leitfähigen Prozesswerkstoff vorliegen.

Bevorzugt ist der leitfähige Prozesswerkstoff ausgewählt ist aus einer Gruppe umfassend ein leitfähiger Klebstoff, ein leitfähiges Lotmaterial oder ein leitfähiges Bondmaterial. Die bevorzugten Materialoptionen für den leitfähigen Prozesswerkstoff gewährleisten sowohl einen akustischen Abschluss als auch eine elektrische Kontaktierung. Zudem kann mittels eines leitfähigen Klebstoffs oder Lotmaterials ein biegeweiche Verbindung erhalten werden, welche das Schwingungsverhalten der Membran begünstigt. Des Weiteren sind die bevorzugten Materialien beständig und sichern eine lange Lebensdauer des MEMS-Wandlers.

In einer weiteren bevorzugten Ausführungsform ist das Verfahren dadurch gekennzeichnet, dass der Träger mit einer Abdeckung verbunden wird, wobei bevorzugt die Abdeckung eine Abdecköffnung aufweist.

Mit der Abdeckung ist bevorzugt eine feste und insbesondere schützende Umhüllung für den MEMS-Wandler gemeint. Insbesondere dient die Abdeckung dem Schutz der Komponenten des MEMS-Wandlers vor Fremdmaterial und/oder Beschädigungen. Somit erstreckt sich die Abdeckung im Wesentlichen über bevorzugten Komponenten des MEMS-Wandlers, beispielsweise über die Membran, elektrischen Verbindungen und/oder eine elektronische Schaltung. Die Abdeckung wird vorzugsweise rückseitig auf dem Träger der Membran positioniert.

Des Weiteren lässt sich durch eine entsprechende Dimensionierung der Abdeckung ein Rückvolumen des MEMS-Wandlers einstellen. Hierdurch kann auf einfache Weise die akustische Performance des MEMS-Wandlers an gewünschte Anwendungen angepasst werden.

Bevorzugt weist die Abdeckung eine Abdecköffnung auf. Vorteilhafterweise können durch das Aufweisen der Abdecköffnung an der Abdeckung die akustischen Eigenschaften des MEMS-Wandlers weiter optimiert werden. Insbesondere führt die Einführung einer Abdecköffnungen zu einer Vergrößerung des effektiven Rückvolumens.

Bevorzugt befinden sich an der Abdeckung Befestigungsbereiche, um den Träger mit der Abdeckung zu verbinden. Dabei können übliche im Stand der Technik bekannte Verfahren eingesetzt werden, wie beispielsweise ein Löten und/oder Kleben. Verschiedene Befestigungsmöglichkeiten und Verfahren dazu liegen im Kenntnisbereich des Fachmanns und sollen nicht näher ausgeführt werden.

In einer weiteren bevorzugten Ausführungsform ist das Verfahren dadurch gekennzeichnet, dass nach der Strukturierung des Membranschichtsystems mehrere Membranen mit einer Trägerstruktur verbunden werden und daraufhin die Formgebungskomponente vollständig entfernt wird.

Mit der Trägerstruktur ist bevorzugt eine strukturelle Vorstufe für die Bereitstellung von einem oder mehreren Trägern gemeint. Die Trägerstruktur ist bevorzugt bereits durch strukturelle Komponenten gekennzeichnet, welche ein Träger für die Membran vorzugsweise aufweist, z. B. eine oder mehrere Schalleintritts- oder Schallaustrittsöffnungen, Durchkontaktierungen und/oder elektronische Schaltungen. Die Trägerstruktur kann bevorzugt mithin als ein Array von Trägerelementen aufgefasst werden, welche in der Trägerstruktur (noch) zusammenhängend vorliegen und durch eine Trennung die Träger bilden.

Bevorzugt weist die Trägerstruktur Ausmaße auf, welche eine passgenaue Anbringung an das Membranschichtsystem ermöglicht, wobei es insbesondere bevorzugt ist, dass jeweils ein Trägerelement an eine zu bildende Membran kontaktiert wird.

Bevorzugt weist die Trägerstruktur ebenfalls eine hinreichende Stabilität auf, um während der vollständigen Entfernung der Formgebungskomponente den Erhalt der Mäanderstruktur der Membranen bzw. des Membranschichtsystems zu gewährleisten. Vorzugsweise wird die Formgebungskomponente erst vollständig entfernt, nachdem die Trägerstruktur mit dem Membranschichtsystem verbunden vorliegt.

Die Anbringung der Trägerstruktur kann bevorzugt nach einer Strukturierung des Membranschichtsystems und mithin einer Vereinzelung des Membranschichtsystems zur Bildung von Membranen unter Einfügung von Unterbrechungen wie obig erläutert erfolgen. Vorzugsweise wird die Trägerstruktur an den Position der Unterbrechungen des Membranschichtsystems, welche den Endbereichen der zu bildenden Membranen entsprechen, über einen leitfähigen Prozesswerkstoff mit dem Membranschichtsystem verbunden.

In einer weiteren bevorzugten Ausführungsform ist das Verfahren dadurch gekennzeichnet, dass nach der vollständigen Entfernung der Formgebungskomponente eine Trägerstruktur bereichsweise getrennt wird, sodass ausgehend von der Trägerstruktur mehrere Träger bereitgestellt werden und jeweils eine Membran an jeweils einem der mehreren Träger angebracht vorliegt.

Mit der bereichsweisen Trennung ist bevorzugt gemeint, dass die Trägerstruktur abschnittsweise aufgetrennt bzw. abgespalten wird. Da die Trägerstruktur bevorzugt als eine Vorstufe von einem oder mehreren Trägern aufzufassen ist, erfolgt durch die abschnittsweise Trennung vorzugsweise ein direkte Bereitstellung der Träger, auf denen bereits die Membranen aufgehangen und elektrisch kontaktiert vorliegen. Zur abschnittsweisen Trennung können im Stand der Technik, je nach Auswahl des Trägermaterials, bewährte Technologien verwandt werden, welche eine präzise und prozesseffiziente Durchführung der bereichsweisen Trennung sicherstellen. Beispielsweise kann ein Dicing bevorzugt sein, welches vorzugsweise Schritte umfasst ausgewählt aus Ritzen, Brechen, Sägen und/oder (Laser-)schneiden.

In bevorzugten Ausführungsformen liegt auf der Trägerstruktur eine Schutzfolie angebracht vor, wobei die Schutzfolie auf der von dem Membranschichtsystem gegenüberliegenden Seite vorliegt und sich vorzugsweise mindestens über den Bereich der Schalleintritts- oder Schallaustrittsöffnungen, vorzugsweise über die gesamte Fläche der Trägerstruktur, erstreckt. Die Schutzfolie kann ein Schutz für die Trägerstruktur bzw. die zu bildenden Träger während unterschiedlicher Prozessierungsschritte, wie beispielsweise einer vollständigen Entfernung der Formgebungskomponenten durch ein Ätzen oder der abschnittsweisen Trennung der Trägerstruktur durch ein Dicing, bieten. Vorzugsweise kann die Schutzfolie als sogenanntes dicing foil einen Endpunkt eine abschnittsweises Trennung durch Dicings darstellen.

In einer bevorzugten Ausführungsform ist das Verfahren dadurch gekennzeichnet, dass eine Trägerstruktur mit mehreren Abdeckungen verbunden wird, wobei bevorzugt die mehreren Abdeckungen eine Abdecköffnung aufweisen.

Bevorzugt erfolgt die Anbringung der mehreren Abdeckungen derart, dass diese auf den Unterbrechungen des strukturierten Membranschichtsystems bzw. der Endbereiche der Membran, für jede einzelne Membran eine passgenaue Abdeckung bereitgestellt wird. Vorzugsweise werden die mehreren Abdeckungen angebracht, bevor die bereichsweise Trennung der Trägerstruktur durchgeführt wird, wodurch eine parallele Prozessierung und erhöhte Effizienz erreicht werden. Ebenso können die Abdeckungen auch nach einer abschnittsweisen Trennung der Trägerstruktur zur Bildung der einzelnen Träger aufgebracht werden.

Die Abdeckungen werden, wie obig erläutert, vorzugsweise rückseitig auf dem Träger angebracht, wobei es bevorzugt sein kann, dass die Abdeckungen eine oder mehrere Abdecköffnungen zur Vergrößerung des Rückvolumens aufweisen.

Der erhaltene MEMS-Wandler umfassend eine schwingfähige Membran, welche von einem Träger gehalten wird und vorzugsweise rückseitig von einer Abdeckung geschützt ist, kann durch den bevorzugten Einsatz einer Bestückungskomponente von der Schutzfolie entfernt und für eine weitere Integration in ein Produkt transportiert bzw. vorbereitet werden.

In einer weiteren bevorzugten Ausführungsform ist das Verfahren dadurch gekennzeichnet, dass die Membran mindestens zwei Lagen umfasst, wobei beide Lagen ein Aktuatormaterial umfassen und mit jeweils einer Elektrode kontaktiert vorliegen und die horizontalen Schwingungen durch eine Formänderung der einen Lage gegenüber der anderen Lage erzeugbar sind oder die horizontale Schwingungen zu einer Formänderung der einen Lage gegenüber der anderen Lage führen und ein elektrisches Signal erzeugen.

In der Ausführungsform werden die horizontalen Schwingungen durch eine relative Formänderung der beiden Aktuatorlagen ermöglicht. Die Aktuatorlagen können hierbei aus demselben Aktuatormaterial bestehen und unterschiedlich angesteuert werden. Auch können die Aktuatorlagen aus unterschiedlichen Aktuatormaterialien bestehen, beispielsweise aus piezoelektrischen Materialien mit unterschiedlichem Deformationskoeffizienten. Die Aktuatorlagen sind hierbei als Teil des Membranschichtsystems aufzufassen, welches bevorzugt auf die Formgebungskomponente wie beschrieben beschichtet werden.

Im Sinne der Erfindung wird die "Lage umfassend ein Aktuatormaterial" bevorzugt auch als Aktuatorlage bezeichnet. Ein Aktuatormaterial meint bevorzugt ein Material, welches unter Anlegung einer elektrischen Spannung eine Formänderung, beispielsweise eine Dehnung, Stauchung oder Scherung erfährt oder umgekehrt unter Formänderung eine elektrische Spannung erzeugt. Bevorzugt sind Materialien mit elektrischen Dipolen, welche durch das Anlegen einer elektrischen Spannung eine Formänderung erfahren, wobei die Orientierung der Dipole und/oder des elektrischen Feldes die Vorzugsrichtung der Formänderungen bestimmen kann. Bevorzugt kann das Aktuatormaterial ausgewählt sein aus einer Gruppe umfassend ein piezoelektrisches Material, ein piezoelektrisches Polymermaterial und/oder elektroaktives Polymer (EAP).

In einer weiteren bevorzugten Ausführungsform ist das Verfahren dadurch gekennzeichnet, dass die Membran mindestens zwei Lagen umfasst, wobei eine erste Lage ein Aktuatormaterial und eine zweite Lage ein mechanisches Stützmaterial umfasst, wobei mindestens die erste Lage umfassend das Aktuatormaterial mit der Elektrode kontaktiert vorliegt, sodass horizontale Schwingungen durch eine Formänderung der Aktuatormaterials gegenüber dem mechanischen Stützmaterial erzeugbar sind oder sodass horizontale Schwingungen zu einer Formänderung des Aktuatormaterials gegenüber dem mechanischen Stützmaterial führen und ein elektrisches Signal erzeugen.

Im Sinne der Erfindung wird die "Lage umfassend ein mechanisches Stützmaterial" bevorzugt auch als Stützlage oder Stützschicht bezeichnet. Das mechanische Stützmaterial bzw. die Stützlage dient bevorzugt als passive Lage, welche einer Formänderung der Aktuatorlage widerstehen kann. Im Gegensatz zu einer Aktuatorlage ändert das mechanische Stützmaterial beim Anlegen einer elektrischen Spannung bevorzugt seine Form nicht. Bevorzugt ist das mechanische Stützmaterial elektrisch leitend, sodass es auch unmittelbar für eine Kontaktierung der Aktuatorlage verwandt werden kann. Es kann aber auch in einigen Ausführungsformen nichtleitend sein und beispielsweise mit einer elektrisch leitfähigen Lage beschichtet vorliegen.

Besonders bevorzugt handelt es sich bei dem mechanischen Stützmaterial um monokristallines Silizium, ein Polysilizium oder ein dotiertes Polysilizium.

Bei Ansteuerung der Aktuatorlage kann diese beispielsweise eine transversale oder longitudinale Streckung oder Stauchung erfahren. Gegenüber der mechanischen Stützschicht wird hierdurch ein Stressgradient erzeugt, welcher zu einer lateralen Wölbung bzw. Schwingung führt. Diese kann beispielsweise durch wechselnde Polung an den Elektroden, bevorzugt durch einen pushpull-Betrieb, erfolgen, wodurch abwechselnd nahezu das gesamte Luftvolumen zwischen den vertikalen Abschnitten in vertikaler Emissionsrichtung bewegt werden kann.

Während die Aktuatorlage bei einer elektrischen Spannung eine Formänderung erfährt, verbleibt die Lage des mechanischen Stützmaterials im Wesentlichen unverändert. Der resultierende Stressgradient zwischen beiden Lagen (mechanischer Bimorph) bewirkt bevorzugt eine horizontale Wölbung. Zu diesem Zweck ist die Dicke der Stützlage im Vergleich zur Dicke der Aktuatorlage bevorzugt so zu wählen, dass für die Wölbung ein hinreichend großer Stressgradient generiert wird. Für dotiertes Polysilizium als mechanisches Stützmaterial und einem piezoelektrischen Material wie PZT oder AIN haben sich beispielsweise im Wesentlichen gleich große Dicke, bevorzugt zwischen 0,5 µm und 2 µm, als besonders geeignet erwiesen.

Eine Kontaktierung der Aktuatorlage und/oder der Lage aus einem mechanischen Stützmaterial und somit das Anlegen einer elektrischen Spannung kann über endseitige Elektroden unmittelbar erfolgen oder durch eine Lage aus einem leitfähigen Material unterstützt werden.

Eine endseitige Positionierung der mindestens eine Elektrode meint bevorzugt, dass eine Kontaktierung mit einer Elektronik, z. B. an eine Strom- oder Spannungsquelle im Falle eines MEMS-Lautsprechers, an einem Ende der schwingfähigen Membran erfolgen kann, bevorzugt an einem Ende, an welchem die Membran am Träger aufgehangen vorliegt. Elektrode meint bevorzugt einen Bereich aus einem leitfähigen Material (bevorzugt einem Metall), welcher für eine solche Kontaktierung mit einer Elektronik, z. B. einer Strom- und/oder Spannungsquelle im Falle eines MEMS-Lautsprechers, eingerichtet ist. Bevorzugt kann es sich um einen leitfähigen Klebestoff, Lötmaterial oder Elektrodenpad handeln. Besonders bevorzugt dient die Elektrode der Kontaktierung mit einer Elektronik und ist selbst mit einer leitfähigen Metallschicht verbunden, welche sich über die gesamte Fläche der schwingfähigen Membran erstrecken kann. Teilweise wird im Folgenden die leitfähige Schicht zusammen mit der endseitigen Kontaktierung durch ein Elektrodenpad oder einen leitfähigen Prozessstoff als Elektrode, beispielsweise als Top-Elektrode oder Bottom-Elektrode, bezeichnet.

In einer bevorzugten Ausführungsform ist das Verfahren dadurch gekennzeichnet, dass die Membran drei Lagen umfasst, wobei eine obere Lage von einem leitfähigen Material gebildet wird und als Top-Elektrode fungiert, eine mittlere Lage von einem Aktuatormaterial gebildet wird und eine untere Lage von einem leitfähigen Material gebildet wird und als Bottom-Elektrode fungiert, wobei das leitfähige Material der oberen und/oder unteren Lage bevorzugt ein mechanisches Stützmaterial ist.

Bevorzugt liegt die Top- und/oder Bottom-Elektrode als eine Lage aus einem leitfähigem Material, bevorzugt Metall, als durchgängige bzw. ganzflächige oder zusammenhängende Schicht der schwingfähigen Membran vor, welche eine im Wesentlichen homogene Fläche bildet und insbesondere im Bereich der einzelnen Membranen nicht strukturiert wird. Stattdessen werden bevorzugt mittels einer unstrukturierten Lage aus einem leitfähigem Material, bevorzugt Metall, die zwei oder mehr vertikalen Abschnitte mit endseitigen Elektroden verbunden, sodass eine Aktuierung der Aktuatorlage zur Anregung der Membran zu Schwingungen oder ein Auslesen eines in der Aktuatorlage erzeugten Signals im Falle einer Anregung der Membran durch Schwingungen ausgehend von einer Elektronik auf dem Träger möglich ist.

Die Bezeichnungen Top und Bottom betreffen bevorzugt die Lage des leitfähigen Materials, sodass in einem Querschnitt davon gesprochen werden kann, dass die Top-Elektrode ein leitfähiges Material. oberhalb (bzw. vorderseitig) auf der Aktuatorlage umfasst und die Bottom-Elektrode ein leitfähiges Material unterhalb (bzw. rückseitig) der Aktuatorlage.

Mittels der Lage aus einem leitfähigem Material, bevorzugt Metall, können vorteilhaft die zwei oder mehr vertikalen Abschnitte mit einer endseitigen Elektrode bzw. einem Elektrodenpad oder leitfähigen Prozesswerkstoff kontaktiert werden.

In weiteren bevorzugten Ausführungsformen eine Lage des leitfähiges Material aus einem Stützmaterial gebildet werden, sodass beispielsweise eine Bottom- und/oder Top-Elektrode gleichzeitig als eine mechanische Stützlage fungiert.

In einer beispielhaften Ausführung wird auf eine Formgebungskomponente zur Bildung eines Membranschichtsystems zunächst eine Opferschicht, dann ein leitfähiges Material für die Bottom-Elektrode, welche gleichzeitig Stützlage dient, daraufhin ein Aktuatormaterial für die Bereitstellung der Aktuatorlage und anschließend ein weiteres leitfähiges Material (welche nicht notwendigerweise ein Stützmaterial ist) für die Bereitstellung der Top-Elektrode beschichtet (vgl. Fig. 2).

In einer weiteren bevorzugten Ausführungsform ist das Verfahren dadurch gekennzeichnet, dass der MEMS-Wandler eine elektronische Schaltung aufweist, wobei die elektronische Schaltung eine elektrische Verbindung mit der Membran aufweist, wobei bevorzugt die elektronische Schaltung auf dem Träger angebracht wird.

Bevorzugt ist die elektronischen Schaltung ohne Beschränkung ausgewählt aus einer Gruppe umfassend eine integrierte Schaltung (IC), eine anwendungsspezifische integrierte Schaltung (ASIC), eine programmierbare logische Schaltung (PLC), ein Field Programmable Gate Array (FPGA), einen Mikroprozessor, einen Mikrocomputer, eine speicherprogrammierbare Steuerung und/oder eine sonstige elektronische Schaltung, die bevorzugt programmierbar ist.

Je nach Verwendung des MEMS-Wandlers, beispielsweise als MEMS-Mikrofon oder MEMS-Lautsprecher, ist die elektronische Schaltung dafür die Membran zu Schwingungen (und mithin zur Erzeugung von Schallwellen) anzuregen und/oder Schwingungen der Membran (aufgrund einer Anregung durch einfallende Schallwellen) zu detektieren.

Im Falle eines MEMS-Mikrofons wird es durch die elektronischen Schaltung vorzugsweise ermöglicht, ein elektrisches Signal auszulesen bzw. zu detektieren, welches beim Auftreten der Schalldruckwellen auf die Membran und der damit verbundenen Anregung der vertikalen Abschnitte zu horizontalen Schwingungen erzeugt wird.

Im Falle eines MEMS-Lautsprechers wird die elektronische Schaltung vorzugsweise dafür eingerichtet sein, ein elektrisches Signal zu erzeugen, um die vertikalen Abschnitte zu Schwingungen anzuregen, sodass Schalldruckwellen entlang einer vertikalen Emissionsrichtung erzeugt werden.

Bevorzugt liegt die elektronische Schaltung auf dem Träger angebracht vor. In Ausführungsformen, in denen eine Trägerstruktur eingesetzt wird, können eine oder mehrere elektronische Schaltungen auf die Trägerstruktur eingebracht sein.

Vorteilhaft liegt hinsichtlich der Auswahl des Trägers eine erhöhte Flexibilität vor in Bezug auf Design und der elektrischen Eigenschaften. Insbesondere kann der Träger neben der Stützung der Membran auch als Schaltungsträger fungieren. Insbesondere wird es ermöglicht, durch den leitfähigen Prozesswerkstoff eine elektrische Kontaktierung zwischen der Membran und leitfähigen Abschnitten des Trägers ermöglicht, beispielsweise Durchkontaktierungen. In einigen Ausführungsformen kann der herstellbare MEMS-Wandler als Bottom-Port-Ausführung vorliegen.

In einer weiteren bevorzugten Ausführungsform ist das Verfahren dadurch gekennzeichnet, dass der Träger ein Material umfasst ausgewählt aus einer Gruppe bestehend aus Aluminium, Keramik, kupferkaschiertes Laminat (CCL) und/oder Glasfaser-Harz, wobei bevorzugt das Glasfaser-Harz ausgewählt ist aus einer Gruppe umfassend FR-4 oder FR-5. Ebenso können auch Halbleitermaterialien einen Einsatz finden, wie diese vorstehend für die Formgebungskomponente offenbart wurden. Durch die getrennte Bereitstellung einer Formgebungskomponente zur Formung des Membranschichtsystems bzw. der Membran und einen separaten Träger, auf den die Membran später angebracht wird, können vorteilhaft jedoch unabhängig von Anforderungen an die Formgebung der Membran Trägermaterialien gewählt werden, welche den Anforderungen an eine mechanische Stabilität, einfacher elektrischer Kontaktierung und Gewährleistung eines optimalen akustischen Klangbilds genügen.

Die vorstehend bevorzugten Materialien für den Träger haben sich dahingehend als vorteilhaft erwiesen, dass sie eine gute Anbindung zwischen Membran und Träger ermöglichen. Insbesondere können vorteilhafterweise weitere Komponenten, wie z. B. Leiterbahnen, Lötinseln, etc., zuverlässig angebracht und/oder bearbeitet werden. Des Weiteren haben sich die genannten Materialien bei unterschiedlichen Einsatz- und Verarbeitungsbereichen als besonders stabil und temperaturbeständig erwiesen.

In einem weiteren Aspekt betrifft die Erfindung einen MEMS-Wandler herstellbar bzw. hergestellt durch eine bevorzugte Ausführungsform des erfindungsgemäßen Verfahrens.

Der durchschnittliche Fachmann erkennt, dass technische Merkmale, Definitionen, Vorteile und bevorzugte Ausführungsformen, welche für das erfindungsgemäßen Verfahren zur Herstellung eines MEMS-Wandlers beschrieben wurden, gleichermaßen für den erfindungsgemäß herstellbaren MEMS-Wandler gelten, und umgekehrt.

Der herstellbare MEMS-Wandler zeichnet sich beispielsweise vorteilhaft durch eine gesteigerte Designfreiheit in Bezug auf die Gestaltung des Trägers sowie der Anbringung der Membran an selbigen aus. Dies wird insbesondere dadurch erreicht, dass die Formgebungskomponente vollständig entfernt wird, anstatt, im Vergleich zum Stand der Technik, ein Substrat bzw. die Formgebungskomponente als Träger beizubehalten. Hierdurch wird eine separate Positionierung an einen beliebigen Träger, wie obig erläutert, ermöglicht. Des Weiteren wirkt sich die vollständige Entfernung der Formgebungskomponente vorteilhaft darauf aus, dass besonders kompakte MEMS-Wandler hergestellt werden können.

Die erfindungsgemäßen Verfahrensschritte zur Herstellung des MEMS-Wandlers führen mithin nicht nur zu einem besonders wirtschaftliches und prozesseffizientes Herstellungsverfahren, sondern resultieren zudem in einer vorteilhaften strukturelle Gestaltung des MEMS-Wandlers.

Die erfindungsgemäßen Verfahrensschritte wirken hierbei unmittelbar auf die strukturellen Eigenschaften des MEMS-Wandler, sodass ein Fachmann ohne größeren Aufwand für einen hergestellten MEMS-Wandler eindeutig feststellen kann, ob dieser mittels des erfindungsgemäßen Verfahrens hergestellt wurde.

Wie durch den Schritt der vollständigen Entfernung der Formgebungskomponente definiert, ist der herstellbare MEMS-Wandler durch die Abwesenheit eines Materials der Formgebungskomponenten gekennzeichnet. Insbesondere liegen rückseitig keine Reststrukturen einer Formgebungskomponente vor, welche - wie beispielsweise in der WO 2021/144400 A1 vorgeschlagen - als Träger fungieren.

Stattdessen erfolgt insbesondere eine Anbringung der Membran an einen separaten Träger, wobei die Kontaktierung von Membran und Träger an einer Vorderseite der schwingfähigen Membran, anstelle rückseitig wie in der WO 2021/144400 A1 vorgeschlagen, erfolgt.

In bevorzugten Ausführungsformen betrifft die Erfindung daher einen MEMS-Wandler zur Interaktion mit einem Volumenstrom eines Fluids umfassend
- einen Träger und
- eine Membran zur Erzeugung oder Aufnahme von Druckwellen des Fluids in einer vertikalen Richtung, welche von dem Träger gehalten wird,
wobei die Membran eine Mäanderstruktur mit vertikalen Abschnitten und horizontalen Abschnitten aufweist, wobei die vertikalen Abschnitte im Wesentlichen parallel zur vertikalen Richtung ausgebildet sind und die horizontalen Abschnitte die vertikalen Abschnitte miteinander verbinden, wobei die Membran mindestens eine Aktuatorlage aus einem Aktuatormaterial umfasst und mit mindestens einer Elektrode kontaktiert vorliegt, sodass durch Ansteuerung der mindestens einen Elektrode die vertikalen Abschnitte zu horizontalen Schwingungen anregbar sind oder sodass bei Anregung der vertikalen Abschnitte zu horizontalen Schwingungen an der mindestens einen Elektrode ein elektrisches Signal erzeugbar ist,
dadurch gekennzeichnet,
dass die Membran an einer Vorderseite an dem Träger angebracht vorliegt. Die Vorderseite meint vorzugsweise die dem Fluid zugewandte Seite der Membran, d.h. jene Seite in deren Richtung durch die Membran Druckwellen erzeugt werden oder aus deren Richtung Druckwellen aufgenommen werden können.

In weiteren bevorzugten Ausführungsformen ist die Membran vorderseitig an einem Träger angebracht, wobei der Träger eine im Wesentlichen durchgehende Umrandung aufweist, sodass die Membran an Endbereichen stabil positioniert werden kann.

In weiteren bevorzugten Ausführungsformen weist der Träger eine oder mehrere Öffnungen auf, die als Schalleintrittsöffnung oder Schallaustrittsöffnung fungieren, je nach Anwendung des MEMS-Wandlers als MEMS-Mikrofon oder als MEMS-Lautsprecher, wobei eine Vorderseite der Membran vorzugsweise der Schalleintrittsöffnung oder Schallaustrittsöffnung zugewandt ist. Besonders bevorzugt dient ein leitfähiger Prozesswerkstoff, beispielsweise ein leitfähiger Klebstoff oder leitfähiges Lötmaterial einer mechanischen und elektrischen Verbindung zwischen dem Träger und der Membran, wodurch, wie obig erläutert, ein besonders guter akustischer Abschluss und stabile elektrische Kontaktierung ermöglicht wird. Nicht nur die Position des Trägers in Bezug auf die Membran, sondern auch die Art der Anbringung ist mithin für einen mittels des erfindungsgemäßen Verfahrens herstellbaren MEMS-Wandler charakteristisch.

Bevorzugt liegt der MEMS-Wandler als Bottom-Port-Ausführung vor, d. h., dass eine oder mehrere Schalleintritts- oder eine Schallaustrittsöffnungen am Träger vorliegen, wobei diese bevorzugt gegenüber einer Rückseite der Membran positioniert sind. Vorteilhaft ist das Rückvolumen von Bottom-Port-Ausführungen eines MEMS-Mikrofons oder MEMS-Lautsprechers größer als das Vorvolumen. Ein großes Luftvolumen im Rückvolumen erleichtert es der Membran, sich unter dem Einfluss der Schallwellen zu bewegen. Dies wiederum verbessert die Leistungsfähigkeit eines MEMS-Lautsprechers oder Empfindlichkeit bzw. das Signal-RauschVerhältnis eines MEMS-Mikrofons.

Die erfindungsgemäßen Aspekte sollen im Folgenden anhand von Beispielen näher erläutert werden, ohne auf diese Beispiele beschränkt zu sein.

### FIGUREN

### Kurzbeschreibung der Figuren

- **Fig. 1**: Vergleich bevorzugter Schritte zur Bereitstellung eines MEMS-Wandlers mit zuvor im Stand der Technik offenbarten Verfahren
- **Fig. 2**: Schematische Darstellung von bevorzugten Schritten zur Beschichtung der Formgebungskomponente mit einem Membranschichtsystem
- **Fig. 3**: Schematische Darstellung von bevorzugten Verfahrensschritten zur weiteren Prozessierung einer Formgebungskomponente mit einem Membranschichtsystem zur Herstellung eines MEMS-Wandlers unter Verwendung einer Stützstruktur und Bestückungskomponente
- **Fig. 4**: Schematische Darstellung von bevorzugten Verfahrensschritten zur weiteren Prozessierung einer Formgebungskomponente mit einem Membranschichtsystem zur Herstellung eines MEMS-Wandlers unter Anbringung des Membranschichtsystem an eine Trägerstruktur

### Detaillierte Beschreibung der Figuren

Fig. 1 dient der Illustration eines MEMS-Wandlers sowie dessen Herstellung gemäß der WO 2021/144400 A1 und einem Vergleich eines mittels des bevorzugten Verfahrens herstellbaren MEMS-Wandler.

Fig. 1A zeigt beispielhaft einen MEMS-Wandler aus der WO 2021/144400 A1. Dabei wird die Membran **5** von einer Trägerbereich bzw. einem Träger **39** gehalten, wobei die Membran **5** sich horizontal zwischen Seitenbereichen der Trägerbereich **39** erstreckt. Die vertikale Richtung zur Erzeugung oder Aufnahme von Druckwellen, insbesondere Schallwellen, liegt orthogonal zur horizontalen Erstreckung der Membran **5** vor. Durch eine Abdeckung **23** wird ein Gehäuse bereitgestellt, wobei die Vorderseite der Membran **5** gegenüber einer Öffnung am Träger **39** gehalten wird. Die Membran **5** weist vertikale Abschnitte **4** auf, welche im Wesentlichen parallel zur vertikalen Richtung ausgebildet sind und mindestens eine Lage aus einem Aktuatormaterial **11** umfassen. Die Membran **5** ist an ihren Endbereichen mit einer Elektrode kontaktiert, sodass durch Ansteuerung der mindestens einen Elektrode die vertikalen Abschnitte **4** zu horizontalen Schwingungen anregbar sind und Druckwellen emittieren können. Umgekehrt können die vertikalen Abschnitte **4** durch Druckwellen zu horizontalen Schwingungen angeregt werden, sodass an der Elektrode ein elektrisches Signal erzeugt werden kann.

Vorteilhaft kann durch die Mehrzahl der vertikalen Abschnitten **4** der schwingfähigen Membran **5** mit geringen horizontalen Bewegungen (Verschiebungen bzw. Wölbungen) von wenigen Mikrometer eine vergrößertes Gesamtvolumen in die vertikale Emissionsrichtung bewegt und so zur Schallerzeugung genutzt werden. Die Gestaltung der schwingfähigen Membran 5 umfassend vertikalen Abschnitte führt mithin im Falle eines MEMS-Lautsprechers zu einer erhöhten Schallleistung. Auch im Falle eines MEMS-Mikrofons wird eine erhöhte Leistungsfähigkeit sowie Audioqualität mit einem geeigneten Klangbild erlangt.

In Fig. 1B und Fig. 1C werden bekannte Verfahrensschritte zur Herstellung von derartigen MEMS-Wandlern illustriert.

Nach dem die Membran **5** auf einem strukturierten Trägersubstrat aufbeschichtet wurde, erfolgt eine Freistellung der Membran **5** kann durch ein DRIE-Ätzen ausgehend von einer Rückseite bereitgestellt werden (siehe Fig. 1B, rechtes Bild, Pfeile von unten). Hierbei verbleiben Randbereiche des Trägersubstrates als Träger **39,** zwischen welchem die Membran **5** aufgehangen vorliegt. Nachteilig ist ein rückseitiges DRIE-Ätzen jedoch aufwendig und kostensensitiv. Darüber hinaus geht ein DRIE-Ätzen mit Einschränkungen bzgl. der Opferschichtenauswahl (Stoppoxide) sowie der Möglichkeit, unterschiedliche Tiefen beim Ätzen zu erreichen, einher. Zudem werden Prozessschritte wie das Grinding, insbesondere auch ein Dicing des Trägerssubstrates für die Bereitstellung einer Mehrzahl von MEMS-Wandlern benötigt.

In Fig. 1C erfolgt eine rückseitige Freistellung des Membran **5** mittels eines KOH-Ätzens, wobei Randbereiche des Trägersubstrates als Träger **39** verbleiben, zwischen welchem die Membran **5** aufgehangen vorliegt. Deutlich zu erkennen ist die vergrößerte Ausdehnung des Trägers **39,** wodurch die Kompaktheit des MEMS-Wandlers kompromittiert wird.

Wie in der Fig. 1D illustriert, führt dies zudem bei der Herstellung einer Vielzahl von MEMS-Wandlern zu einem erhöhten Platzbedarf zwischen den einzelnen MEMS-Wandlern und mithin zu einer weniger effizienten Nutzung des Wafers und erhöhten Kosten.

Fig. 1E illustriert schematischen die vorgesehene vollständige (rückseitige) Entfernung einer Formgebungskomponente bzw. Trägersubstrates (unten), welche im Gegensatz zu den vorher illustrierten Verfahren steht, bei denen Randbereiche eines strukturierten Substrates belassen werden, um als Träger **39** für die Membran **5** zu fungieren (oben, durchgestrichen).

Fig. 2 zeigt schematisch bevorzugte Schritte der Beschichtung der Formgebungskomponente **7** mit einem Membranschichtsystem **9.** Die Beschichtung des Membranschichtsystems **9** auf der Formgebungskomponente **7** erfolgt ausgehend von einer Vorderseite.

In Fig. 2A ist die Formgebungskomponente **7** dargestellt, die zunächst bereitgestellt wird, bevor die Beschichtung des Membranschichtsystems **9** erfolgt. Die Formgebungskomponente **7** wird hierbei als Kammstruktursubstrat **7** umfassend Kammfinger **43** und Leerbereiche **45** bereitgestellt. Durch die Struktur der Formgebungskomponente 7 (z. B. durch die Länge und/oder Breite der Kammfinger **43** und/oder Leerbereiche **45)** kann die Mäanderstruktur der zu erhaltenen Membran eingestellt werden. Die Bereitstellung der Formgebungskomponente **7** kann beispielsweise mittels eines DRIE-Ätzverfahrens oder KOH-Ätzens erfolgen.

In Fig. 2B wird zunächst die Beschichtung einer Opferschicht **35** auf die Formgebungskomponente dargestellt. Die Opferschicht **35** dient insbesondere dem Schutz der Membran bzw. des Membranschichtsystems **9** bei der Entfernung der Formgebungskomponente **7,** vorzugsweise mittels eines nasschemischen Ätzens. Bei der Opferschicht **35** kann es sich beispielsweise um TEOS oder PECVD handeln.

Auf die Opferschicht **35** wird, wie in Fig. 2C gezeigt, eine Lage aus einem leitfähigen Material beschichtet, die für die Membran als Bottom-Elektrode **29** fungieren kann. Daraufhin ist in Fig. 2D die Beschichtung einer Aktuatorlage **11** umfassend ein Aktuatormaterial, beispielsweise eines piezoelektrischen Materials, dargestellt. Bevorzugt kann das piezoelektrische Material eine c-Achsen Orientierung senkrecht zur Oberfläche aufweisen, wobei auch andere Orientierungen möglich sind. In Fig. 2E wird die Beschichtungen einer weiteren Lage eines elektrisch leitfähigen Material zur Bildung einer Top-Elektrode **27** gezeigt.

Damit umfasst das Membranschichtsystem **9** auf der Formgebungskomponente eine Opferschicht **35,** eine Bottom-Elektrode **29,** eine Aktuatorlage **11** und eine Top-Elektrode **27.** Es versteht sich, dass die Opferschicht **35** im weiteren Herstellungsprozess des MEMS-Wandlers vorzugsweise entfernt wird, sodass die Membran **5** im fertiggestellten MEMS-Wandler eine obere Lage als Top-Elektrode **27,** eine mittlere Lage als Aktuatorlage **11** und eine Bottom-Elektrode **29** aufweist. Die Bottom-Elektrode **29** kann vorzugsweise aus einem leitfähigen Stützmaterial gebildet sein, sodass diese gleichzeitig als passive Stützlage fungiert.

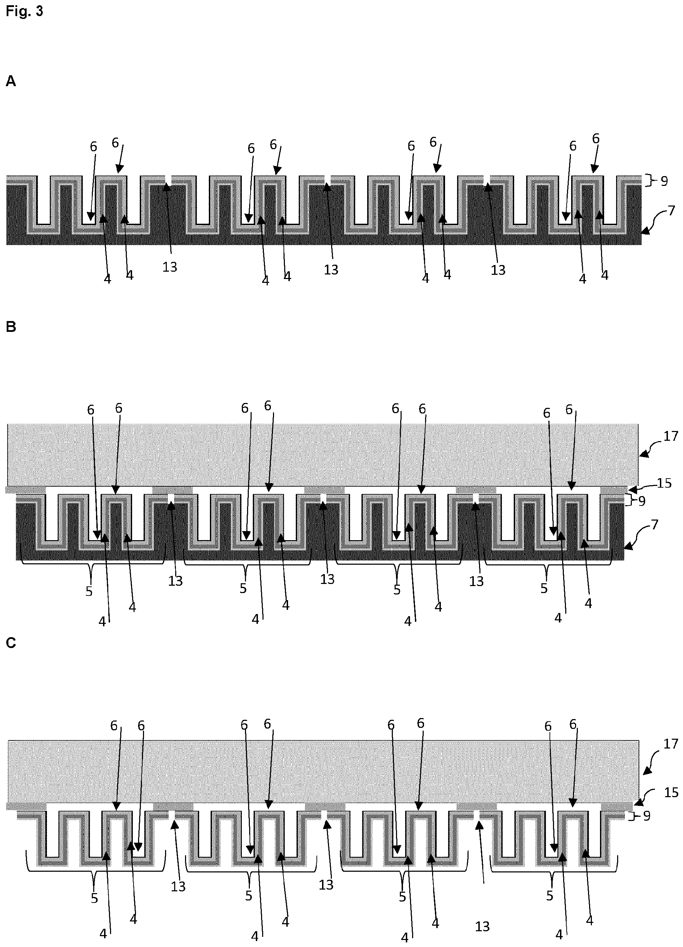

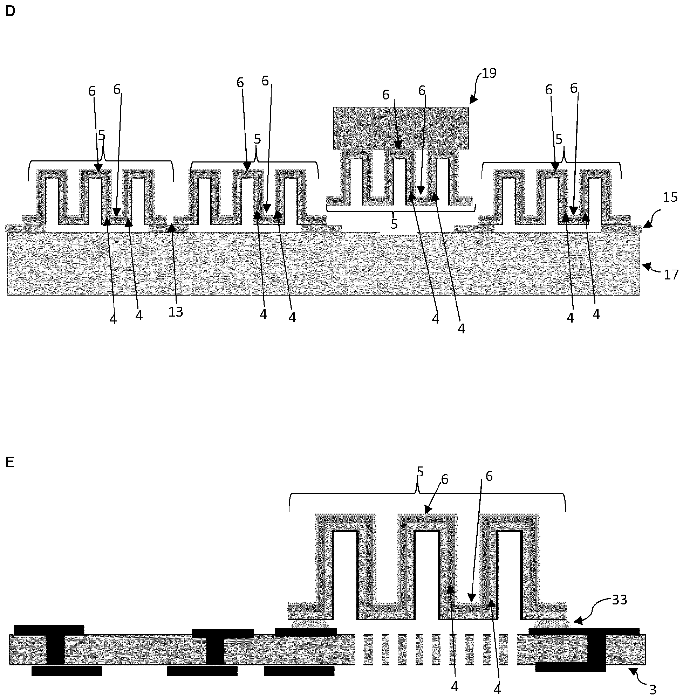

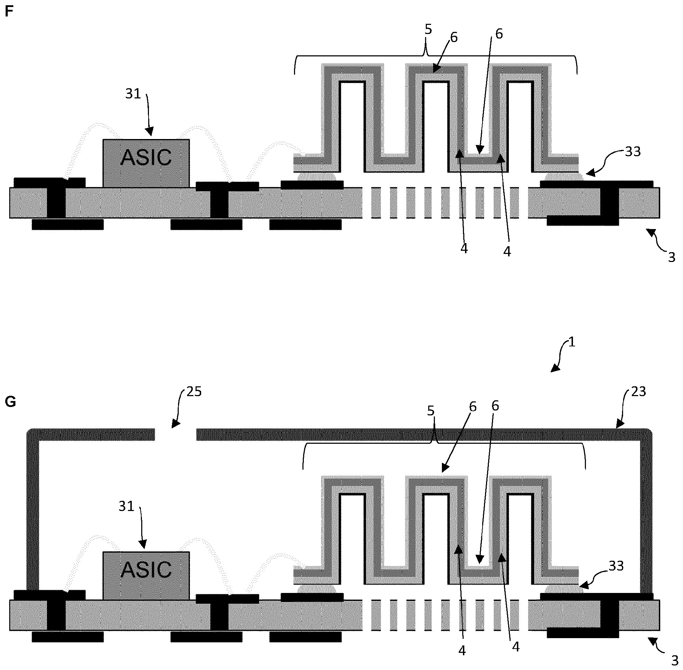

Fig. 3 zeigt bevorzugte Verfahrensschritte zur weiteren Prozessierung der Formgebungskomponente **7** mit Membranschichtsystem **9** gemäß Fig. 2 zur Herstellung eines MEMS-Wandlers unter Verwendung einer Stützstruktur **17** und Bestückungskomponente **19.**

In Fig. 3A wird das Membranschichtsystem **9** auf der Formgebungskomponente **7** dargestellt. Das Membranschichtsystem weist nach der Beschichtung auf der Formgebungskomponente **7** vertikale Abschnitte **4** und horizontale Abschnitte **6** auf. Weiterhin wird in Fig. 3A gezeigt, dass das Membranschichtsystem **9** Unterbrechungen **13** aufweisen kann, wobei die Unterbrechungen **13** durch eine Strukturierung des Membranschichtsystems **9,** insbesondere durch eine laterale Strukturierung, gebildet werden. Mithin kann mittels einer einzelnen Formgebungskomponente **7** eine Mehrzahl von Membranen **5** bereitgestellt werden. Dazu erfolgt zunächst die Aufbringung eines Membranschichtsystems **9** auf der strukturierten Vorderseite der Formgebungskomponente **7.** Zur Definition der einzelnen Membran **5** werden durch eine laterale Strukturierung des Membranschichtsystems **9** vorzugsweise Unterbrechungen **13** gebildet. Wie in der Fig. 3A illustriert, werden die Unterbrechungen **13** vorzugsweise auf den Kammfingern **43** gebildet und liegen mithin im Bereich der horizontaler Abschnitte **6** der Membran **5** vor, welche die vertikalen Abschnitte **4** am oberen bzw. vorderseitigen Ende miteinander verbinden.

In Fig. 3B wird eine Verbindung des Membranschichtsystems **9** nach dessen Strukturierung mittels einer lösbaren Verbindung **15** an einer Stützstruktur **17** illustriert. Dabei kann die lösbare Verbindung einen Klebstoff beispielsweise einen UV-Klebstoff umfassen.

Durch eine Verbindung mit der Stützstruktur **17** kann vorteilhafterweise jene Stabilität für die Membranen **5** gesichert werden, welche nach der vollständigen Entfernung der Formgebungskomponente **7** benötigt wird. Mithin wird durch die Stützstruktur **17** vorteilhafterweise eine Beibehaltung der Mäanderstruktur der Membranen **5** gewährleistet und das Risiko eines Formverlustes reduziert. Da die Stützstruktur **17** selbst nicht Bestandteil des MEMS-Wandlers ist, sondern lediglich der vorübergehenden Stabilisierung der Membranen **5** dient, kann die Stützstruktur **17** unter kostentechnischen Gesichtspunkten ausgewählt werden. Die Stützstruktur **17** kann beispielsweise aus einem flachen Kunststoffsubstrat oder als Folie, vorzugsweise als Klebefolie, ausgebildet sein.

Eine lösbare Verbindung **15** der Membranen **5** mit der Stützstruktur **17** dient der späteren Übergabe der Membranen **5** an die Träger. Die lösbare Verbindung **15** liegt zu diesem Zweck bevorzugt derart vor, dass sie entlang der Unterbrechungen **13** des Membranschichtsystems **9** und damit der Endbereiche der einzelnen Membranen **5** aufgebracht ist. Bei der lösbaren Verbindung handelt es sich vorzugsweise um eine dekomposierbare Verbindung, sodass ausgehend von dem Membranschichtsystem **9** die Membranen **5** frei von etwaigen Schädigungen und damit zuverlässig entfernt werden können.

Fig. 3C zeigt die vollständige Entfernung der Formgebungskomponente **7.** Die vollständige Entfernung der Formgebungskomponente kann vorzugsweise mithilfe eines nasschemischen Ätzverfahrens erfolgen, insbesondere durch ein KOH- und/oder TMAH-Ätzen. Vorteilhaft können durch den Einsatz nasschemischer Ätzverfahren zur vollständigen Entfernung der Formgebungskomponente **7** dünne Opferschichten **35** eingesetzt und Material gespart werden. Zudem gibt es aufgrund der hohen Selektivität nasschemischer Ätzverfahren auch eine höhere Materialauswahl hinsichtlich der Opferschichten **35** als z. B. bei einem DRIE-Ätzverfahren.

In Fig. 3D wird schematisch eine Entfernung der Membran **5** von der Stützstruktur **17** durch eine Bestückungskomponente **19** illustriert. Die Bestückungskomponente **17** kann beispielsweise dazu eingestellt sein, einen Niederdruck aufzubringen, sodass durch einen Druckunterschied die Membran **5** von der lösbaren Verbindung **15** bzw. der Stützstruktur **17** gelöst wird. Ebenfalls kann als Bestückungskomponente **19** eine Vakuumspannvorrichtung, eine Drucknadel und/oder ein Pick-and-Place-Tool verwandt werden.

Die vorgenannten Optionen der Bestückungskomponente **19** haben sich als besonders zuverlässig erwiesen, um bei einem Transport von der Stützstruktur **17** zum Träger die Form der filigranen Bestandteilen der Membran **5** nicht zu beeinträchtigen.

Nach der Entfernung der Membran **5** unter Einsatz der Bestückungskomponente **19** wird die Membran **5** auf einen Träger **3** über einen leitfähigen Prozesswerkstoff **33** angebracht, wie in Fig. 3E gezeigt wird. Bei dem Träger **3** handelt es sich um eine Struktur, welche vorzugsweise eine im Wesentlichen durchgehende Umrandung aufweist, sodass die Membran **5** an lateralen Endbereichen stabil positioniert werden kann. Bevorzugt weist der Träger **3** eine oder mehrere Öffnungen auf, die als Schalleintrittsöffnung oder Schallaustrittsöffnung fungieren, je nach Anwendung des MEMS-Wandlers als MEMS-Mikrofon oder als MEMS-Lautsprecher. Der leitfähige Prozesswerkstoff **33** dient der stabilen Verbindung zwischen dem Träger **3** und der Membran **5.** Des Weiteren wird durch den leitfähigen Prozesswerkstoff **33** ein akustischer Abschluss und eine elektrische Kontaktierungsmöglichkeit mit einer elektronischen Schaltung **31** ermöglicht.

In Fig. 3F wird dargestellt, dass eine elektronische Schaltung **31** (hier: "ASIC") bevorzugt auf den Träger **3** angebracht wird. Je nach Verwendung des MEMS-Wandlers, beispielsweise als MEMS-Mikrofon oder MEMS-Lautsprecher, ist die elektronische Schaltung **31** vorzugsweise dafür eingerichtet die Membran **5** zu Schwingungen (und mithin zur Erzeugung von Schallwellen) anzuregen und/oder Schwingungen der Membran **5** (aufgrund einer Anregung durch einfallende Schallwellen) zu detektieren.

Anschließend kann der Träger **3** mit einer Abdeckung **23** verbunden werden, wobei die Abdeckung **23** eine Abdecköffnung **25** aufweist (Fig. 1 G). Mittels der Abdeckung **25** wird eine feste und schützende Umhüllung für den MEMS-Wandler aufgebracht, insbesondere um Komponenten des MEMS-Wandlers **1** zu schützen. Somit erstreckt sich die Abdeckung **23** im Wesentlichen über sämtlichen Komponenten des MEMS-Wandlers, beispielsweise über die Membran **5,** elektrischen Verbindungen und die elektronischen Schaltung **31.** Weiterhin bieten die Ausmaße der Abdeckung **25** die Möglichkeit, das Rückvolumen des MEMS-Wandlers **1** im Hinblick auf gewünschte akustischen Eigenschaften einzustellen.

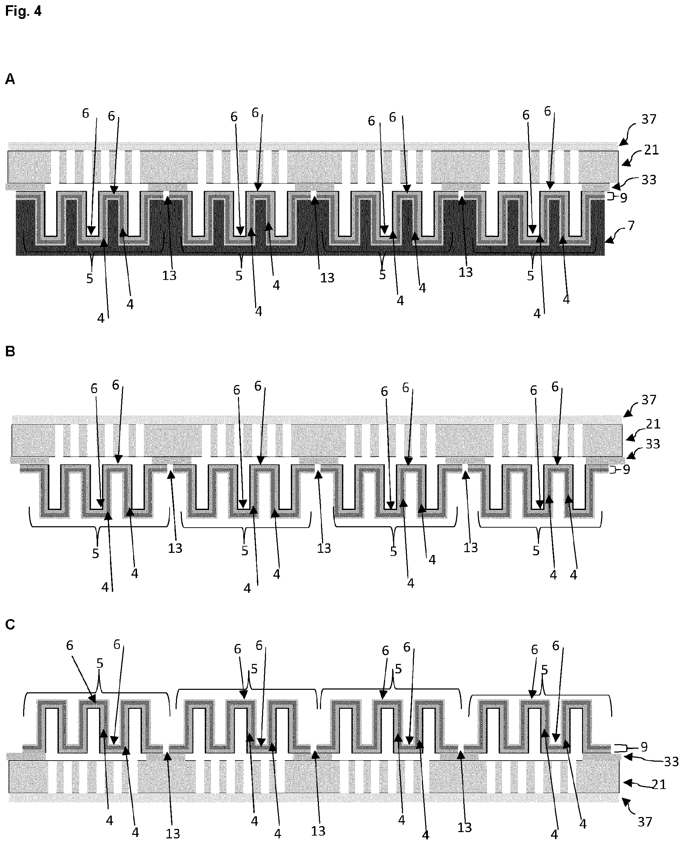

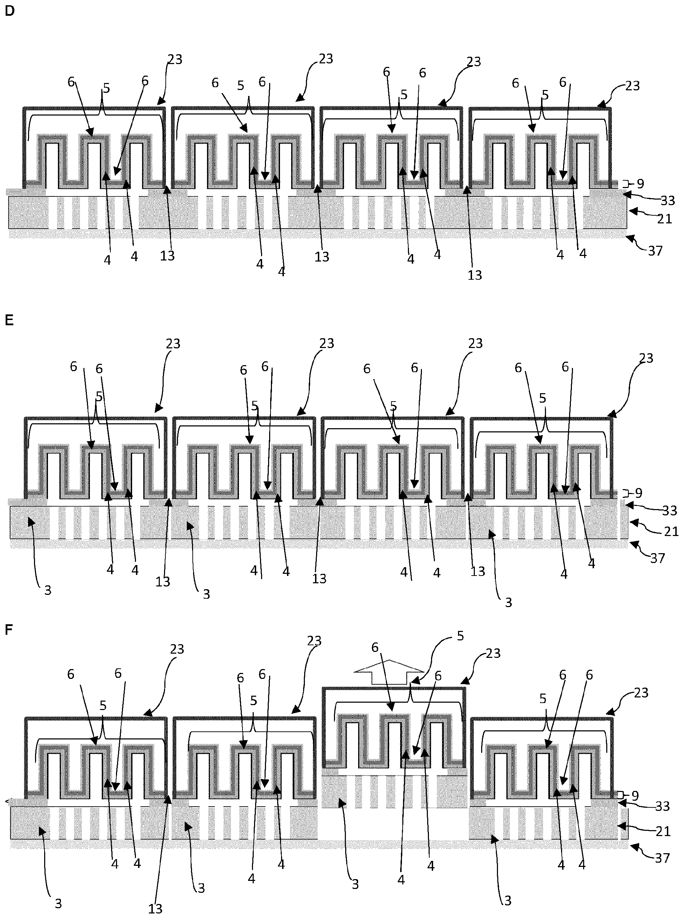

Fig. 4 zeigt bevorzugte Verfahrensschritte zur weiteren Prozessierung der Formgebungskomponente **7** mit Membranschichtsystem **9** gemäß Fig. 2 zur Herstellung eines MEMS-Wandlers unter Anbringung des Membranschichtsystem **9** an eine Trägerstruktur **21.**

In Fig. 4A wird die Verbindung der Membranen **5** bzw. des Membranschichtsystems **9** mit einer Trägerstruktur **21** dargestellt. Die Verbindung zwischen den Membranen **5** und der Trägerstruktur **21** kann durch einen leitfähigen Prozesswerkstoff **33** realisiert werden. Bevorzugt erfolgt die Anbringung der Trägerstruktur **21** nach der Strukturierung des Membranschichtsystems **9** um Unterbrechungen **13** zu bilden.

Die Trägerstruktur **21** kennzeichnet bevorzugt eine strukturelle Vorstufe für die Bereitstellung von einem oder mehreren Trägern und kann auch als ein Array von Trägerelemente aufgefasst werden, welche in der Trägerstruktur **21** (noch) zusammenhängend vorliegen und durch eine Trennung die Träger bilden werden. Die Trägerstruktur **21** kann zu diesem Zweck bereits eine Reihe strukturelle Komponente eines Trägers aufweisen, hier z. B. mehrere Schalleintritts- oder Schallaustrittsöffnungen. Es kann aber auch bevorzugt sein, dass nach der Vereinzelung der Trägerstruktur **21** weitere Bearbeitungsschritte folgen

Vorzugsweise ist die Trägerstruktur **21** durch eine hinreichende Stabilität gekennzeichnet, um während der vollständigen Entfernung der Formgebungskomponente **7** den Erhalt der Mäanderstruktur der Membranen **5** zu gewährleisten. Die Formgebungskomponente wird bevorzugt mithin erst vollständig entfernt, nachdem die Trägerstruktur **21** mit dem Membranschichtsystem **9** verbunden vorliegt.

Die Anbringung der Trägerstruktur **21** erfolgt vorzugsweise nach einer Strukturierung des Membranschichtsystems **9** und mithin einer Vereinzelung des Membranschichtsystems **9** zur Bildung von Membranen **5** unter Einfügung von Unterbrechungen **13.** Die Trägerstruktur **21** wird vorzugsweise an den Position der Unterbrechungen **13** des Membranschichtsystems **9,** welche den Endbereichen der zu bildenden Membranen **5** entsprechen, über einen leitfähigen Prozesswerkstoff **33** mit dem Membranschichtsystem **9** verbunden.

Ebenfalls ist dargestellt, dass auf der Trägerstruktur **21** vorzugsweise eine Schutzfolie **37** angebracht ist, wobei die Schutzfolie **37** auf der von dem Membranschichtsystem **9** gegenüberliegenden Seite vorliegt und sich entlang der gesamten Fläche der Trägerstruktur **21** erstreckt. Die Schutzfolie **37** kann ein Schutz für die Trägerstruktur **21** bzw. die zu bildenden Träger während unterschiedlicher Prozessierungsschritte darstellen, wie beispielsweise einer Entfernung der Formgebungskomponenten **7** oder einer abschnittsweisen Trennung der Trägerstruktur **21** durch ein Dicing. Die Schutzfolie **37** kann hierbei auch als sogenanntes dicing foil einen Endpunkt für das Dicings definieren.

Fig. 4B illustriert die vollständige Entfernung der Formgebungskomponente. In Fig. 4C ist die dieselbe Darstellung wie in der Fig. 4B zu erkennen, allerdings in umgedrehter Ansicht um einen möglichen Weitertransport und/oder Positionierung für die weiteren Bearbeitungsschritte zu illustrieren.

In Fig. 4D wird die Verbindung mehrerer Abdeckungen **23** mit der Trägerstruktur **21** gezeigt. Die Verbindung erfolgt bevorzugt derart, dass die Abdeckungen **23** auf die Position der Unterbrechungen **13** angebracht werden, sodass für jede Membran **5** eine passgenaue Abdeckung **23** vorliegt.

Fig. 4E zeigt die bereichsweise Trennung der Trägerstruktur **21.** Die bereichsweise Trennung kann beispielsweise durch ein Dicing erfolgen.

Wie in Fig. 4F illustriert, können nach der bereichsweisen Trennung der Trägerstruktur **21** die MEMS-Wandler **1** von der Schutzfolie entfernt und/oder eine weiterer Bearbeitung zugeführt werden. Zu diesem Zweck kann eine Bestückungskomponente wie obig beschrieben zum Einsatz kommen.

### BEZUGZSZEICHENLISTE

- 1: MEMS-Wandler
- 3: Träger
- 4: Vertikaler Abschnitt
- 5: Membran
- 6: Horizontaler Abschnitt
- 7: Formgebungskomponente
- 9: Membranschichtsystem
- 11: Aktuatorlage
- 13: Unterbrechung
- 15: Lösbare Verbindung
- 17: Stützstruktur
- 19: Bestückungskomponente
- 21: Trägerstruktur
- 23: Abdeckung
- 25: Abdecköffnung
- 27: Top-Elektrode
- 29: Bottom-Elektrode
- 31: elektronische Schaltung
- 33: Leitfähiger Prozesswerkstoff
- 35: Opferschicht
- 37: Schutzfolie
- 39: Rückseitiger Träger bzw. Trägerbereich aus dem Stand der Technik
- 43: Kammfinger
- 45: Leerbereich

### LITERATURVERZEICHNIS

Kaiser B., Sergiu Langa, Lutz Ehrig, Michael Stolz, Hermann Schenk, Holger Conrad, Harald Schenk, Klaus Schimmanz und David Schuffenhauer, Concept and proof for an all-silicon MEMS microspeaker utilizing air chambers Microsystems & Nanoengineering volume 5, Article number: 43 (2019).
Shahosseini I., Elie LEFEUVRE, Johan Moulin, Marion Woytasik, Emile Martincic, et al. Electromagnetic MEMS Microspeaker for Portable Electronic Devices. Microsystem Technologies, Springer Verlag (Germany), 2013, pp.10. <hal-01103612>.
Stoppel F., C. Eisermann, S. Gu-Stoppel, D. Kaden, T. Giese and B. Wagner, NOVEL MEMBRANE-LESS TWO-WAY MEMS LOUDSPEAKER BASED ON PIEZOELECTRIC DUAL-CONCENTRIC ACTUATORS, Transducers 2017, Kaohsiung, TAIWAN, June 18-22, 2017.

## Patentansprüche

1. Verfahren zur Herstellung mindestens eines MEMS-Wandlers (1) zur Interaktion mit einem Volumenstrom eines Fluids umfassend
- einen Träger (3) und
- eine Membran (5) zur Erzeugung oder Aufnahme von Druckwellen des Fluids in einer vertikalen Richtung, welche von dem Träger (3) gehalten wird,
wobei die Membran (5) eine Mäanderstruktur mit vertikalen Abschnitten (4) und horizontalen Abschnitten (6) aufweist, wobei die vertikalen Abschnitte (4) im Wesentlichen parallel zur vertikalen Richtung ausgebildet sind und die horizontalen Abschnitte (6) die vertikalen Abschnitte (4) miteinander verbinden, wobei die Membran (5) mindestens eine Aktuatorlage (11) aus einem Aktuatormaterial umfasst und mit mindestens einer Elektrode kontaktiert vorliegt, sodass durch Ansteuerung der mindestens einen Elektrode die vertikalen Abschnitte (4) zu horizontalen Schwingungen anregbar sind oder sodass bei Anregung der vertikalen Abschnitte (4) zu horizontalen Schwingungen an der mindestens einen Elektrode ein elektrisches Signal erzeugbar ist, **dadurch gekennzeichnet, dass**
das Verfahren folgende Schritte umfasst:
a) Bereitstellung einer Formgebungskomponente (7),
b) Beschichtung der Formgebungskomponente (7) mit einem Membranschichtsystem (9) umfassend mindestens die Aktuatorlage (11), wobei das Membranschichtsystem (9) nach der Beschichtung auf der Formgebungskomponente (7) eine Mäanderstruktur umfassend vertikale Abschnitte (4) und horizontale Abschnitte (6) aufweist,
c) Bereitstellung der Membran (5) durch eine Strukturierung des Membranschichtsystems (9),
d) vollständige Entfernung der Formgebungskomponente (7),
e) Anbringung der Membran (5) an einem Träger (3), sodass die Membran (5) von dem Träger (3) gehalten wird.

2. Verfahren nach dem vorherigen Anspruch
**dadurch gekennzeichnet, dass**
eine Mehrzahl von MEMS-Wandlern (1) hergestellt wird, wobei für eine Herstellung der Mehrzahl von MEMS-Wandlern (1) das Membranschichtsystem (9) auf der Formgebungskomponente (7) zur Bildung von einzelnen Membranen (5) strukturiert wird, wobei bevorzugt die einzelnen Membranen durch Unterbrechungen (13) getrennt vorliegen, welche vorzugsweise gesamtheitlich nach der Beschichtung des Membranschichtsystems (9) oder Schicht für Schicht gebildet werden.

3. Verfahren nach einem oder mehreren der vorherigen Ansprüche
**dadurch gekennzeichnet, dass**
die Formgebungskomponente (7) durch eine Anwendung eines Trockenätzverfahrens und/oder eines nasschemischen Ätzverfahrens auf ein Substrat bereitgestellt wird, wobei bevorzugt das Trockenätzverfahren ein physikalisches, ein chemisches und/oder ein physikalisch-chemisches Trockenätzverfahren ist, wobei besonders bevorzugt das Trockenätzverfahren ausgewählt ist aus einer Gruppe umfassend reaktives lonenätzen (RIE) und/oder reaktives lonentiefenätzen (DRIE), wobei bevorzugt als nasschemisches Ätzverfahren ein KOH-Ätzen eingesetzt wird.

4. Verfahren nach einem oder mehreren der vorherigen Ansprüche
**dadurch gekennzeichnet, dass**
die Formgebungskomponente (7) durch ein nasschemisches Ätzverfahren, ein Trockenätzverfahren und/oder eines Dampfätzverfahren vollständig entfernt wird, wobei bevorzugt das nasschemische Ätzverfahren ausgewählt ist aus einer Gruppe umfassend KOH- und/oder ein TMAH-Ätzen.

5. Verfahren nach einem oder mehreren der vorherigen Ansprüche
**dadurch gekennzeichnet, dass**
nach der Strukturierung des Membranschichtsystems (9) mehrere Membranen (5) mithilfe einer lösbaren Verbindung (15) mit einer Stützstruktur (17) verbunden werden.

6. Verfahren nach einem oder mehreren der vorherigen Ansprüche
**dadurch gekennzeichnet, dass**
die Membran (5) durch eine Bestückungskomponente (19) von einer Stützstruktur (17) entfernt wird, wobei bevorzugt nach einer Entfernung der Membran (5) von der Stützstruktur (17) die Membran (5) an dem Träger (3) angebracht wird.

7. Verfahren nach einem oder mehreren der vorherigen Ansprüche
**dadurch gekennzeichnet, dass**
die Membran (5) an dem Träger (4) über einen leitfähigen Prozesswerkstoff (33) angebracht wird, wobei bevorzugt der leitfähige Prozesswerkstoff (33) ausgewählt ist aus einer Gruppe umfassend ein leitfähiger Klebstoff oder ein leitfähiges Lotmaterial.

8. Verfahren nach einem oder mehreren der vorherigen Ansprüche
**dadurch gekennzeichnet, dass**
der Träger (3) mit einer Abdeckung (23) verbunden wird, wobei bevorzugt die Abdeckung (23) eine Abdecköffnung (25) aufweist.

9. Verfahren nach einem oder mehreren der vorherigen Ansprüche
**dadurch gekennzeichnet, dass**
nach der Strukturierung des Membranschichtsystems (9) mehrere Membranen (5) mit einer Trägerstruktur (21) verbunden werden und daraufhin die Formgebungskomponente (7) vollständig entfernt wird.

10. Verfahren nach einem oder mehreren der vorherigen Ansprüche
**dadurch gekennzeichnet, dass**
nach der vollständigen Entfernung der Formgebungskomponente (7) eine Trägerstruktur (21) bereichsweise getrennt wird, sodass ausgehend von der Trägerstruktur (21) mehrere Träger (3) bereitgestellt werden und jeweils eine Membran (5) an jeweils einem der mehreren Träger (3) angebracht vorliegt.

11. Verfahren nach einem oder mehreren der vorherigen Ansprüche
**dadurch gekennzeichnet, dass**
eine Trägerstruktur (21) mit mehreren Abdeckungen (23) verbunden wird, wobei bevorzugt die mehreren Abdeckungen (23) eine Abdecköffnung (25) aufweisen.

12. Verfahren nach einem oder mehreren der vorherigen Ansprüche
**dadurch gekennzeichnet, dass**
die Membran (5) mindestens zwei Lagen umfasst, wobei beide Lagen (11) ein Aktuatormaterial umfassen und mit jeweils einer Elektrode kontaktiert vorliegen und die horizontalen Schwingungen durch eine Formänderung der einen Lage gegenüber der anderen Lage erzeugbar sind oder
die horizontale Schwingungen zu einer Formänderung der einen Lage gegenüber der anderen Lage führen und ein elektrisches Signal erzeugen.

13. Verfahren nach einem oder mehreren der vorherigen Ansprüche
**dadurch gekennzeichnet, dass**
die Membran mindestens zwei Lagen umfasst, wobei eine erste Lage (11) ein Aktuatormaterial umfasst und eine zweite Lage ein mechanisches Stützmaterial umfasst, wobei mindestens die erste Lage (11) umfassend das Aktuatormaterial mit der Elektrode kontaktiert vorliegt,
sodass horizontale Schwingungen durch eine Formänderung der Aktuatormaterials gegenüber dem mechanischen Stützmaterial erzeugbar sind oder
sodass horizontale Schwingungen zu einer Formänderung des Aktuatormaterials gegenüber dem mechanischen Stützmaterial führen und ein elektrisches Signal erzeugen.

14. Verfahren nach einem oder mehreren der vorherigen Ansprüche
**dadurch gekennzeichnet, dass**
die Membran (5) drei Lagen umfasst, wobei eine obere Lage von einem leitfähigen Material gebildet wird und als Top-Elektrode (27) fungiert, eine mittlere Lage (11) von einem Aktuatormaterial gebildet wird und eine untere Lage von einem leitfähigen Material gebildet wird und als Bottom-Elektrode (29) fungiert, wobei das leitfähige Material der oberen und/oder unteren Lage bevorzugt ein mechanisches Stützmaterial ist.

15. MEMS-Wandler (1) herstellbar nach einem Verfahren nach einem oder mehreren der vorherigen Ansprüche.
